(19) Europäisches Patentamt
European Patent Office
Office européen des brevets

(11) EP 1 333 497 A2

(12) EUROPEAN PATENT APPLICATION

(43) Date of publication:
**06.08.2003 Bulletin 2003/32**

(51) Int Cl.7: **H01L 27/00**, H01L 27/15

(21) Application number: **03250647.9**

(22) Date of filing: **31.01.2003**

(84) Designated Contracting States:
**AT BE BG CH CY CZ DE DK EE ES FI FR GB GR HU IE IT LI LU MC NL PT SE SI SK TR**
Designated Extension States:
**AL LT LV MK RO**

(30) Priority: **01.02.2002 JP 2002026132**
**30.01.2003 JP 2003022022**

(71) Applicant: **SEIKO EPSON CORPORATION**
**Tokyo 160-0811 (JP)**

(72) Inventor: **Miyazawa, Takashi,**
**Seiko Epson Corporation**
**Suwa-shi, Nagano-ken 392-8502 (JP)**

(74) Representative: **Sturt, Clifford Mark et al**
**Miller Sturt Kenyon,**
**9 John Street**
**London WC1N 2ES (GB)**

(54) **Circuit substrate, electro-optical device and electronic appliances**

(57) The invention seeks to stably operate active elements such as transistors and to enable a display device to have a wide screen and to be stably operated for a long period of time. The electro-optical device (1) comprises an electro-optical element interposed between a cathode (222) and an anode (23) and disposed on the substrate (2), active elements (24) addressing the electro-optical device, and insulating layers (283 and 284) comprising an insulating material interposed between at least one of the cathode (222) and anode (23) and substrate (2) and having a dielectric constant smaller than a prescribed value.

FIG. 3

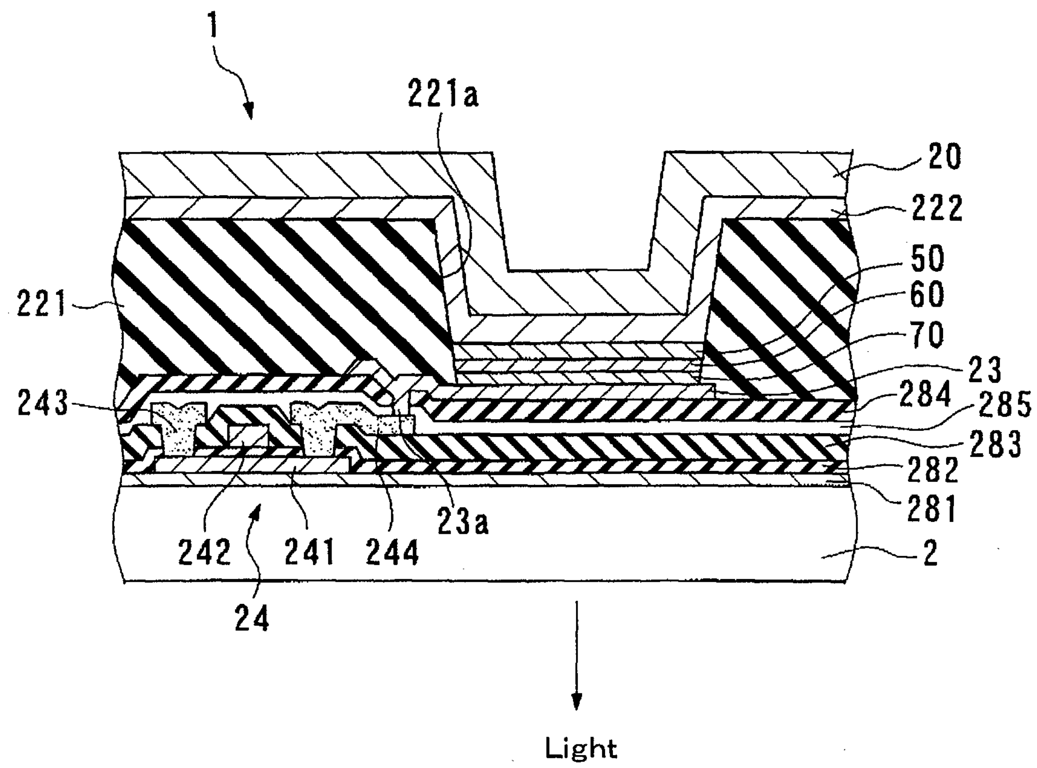


EP 1 333 497 A2

## Description

The invention relates to a circuit substrate comprising a plurality of material layers including an active element and suitable for an electro-optical device and a semiconductor device, the electro-optical device provided with the circuit substrate comprising a plurality of material layers including an electro-optical element and the active element, and electronic appliances comprising the electro-optical device.

Display devices include a liquid crystal display and an organic EL (Electroluminescence) display comprising liquid crystal elements and organic EL elements. The organic EL display is particularly excellent in display performance since it spontaneously emits a highly luminous light, is able to be addressed by a low direct-current voltage, and has a high response speed. The organic EL display is able to be thin and light weight with low consumption of electric power.

The organic EL display comprises a luminous layer containing a luminous substance interposed between electrode layers of an anode and a cathode. Positive holes injected from the anode side and electrons injected from the cathode side are recombined in the luminous layer having a light emitting ability, and a light is emitted when the electrons are deactivated from an excited state.

However, it is known in the electro-optical device that rewriting of data is interfered with by a parasitic capacitance formed between conductive members such as wiring lines and electrodes. The capacitance between the wiring lines depends on the length of the wiring line with an increase in accordance with the length of the wiring line. Accordingly, forming a wide screen display has been difficult due to the parasitic capacitance when the electro-opticaldevice is used as a display.

The capacitance generated between the conductive members such as the wiring lines has been a crucial problem for complying with current requirements of high degree of integration of semiconductor devices such as memories as well as for enhancing the operation speed.

The object of the invention for solving the above problems is to provide a circuit substrate that is able to stably operate active elements such as a transistor, an electro-optical device that is able to have a wide screen and can be stably operated for a long period of time, and electronic appliances using such circuit substrate and electro-optical device.

For attaining the object above, a circuit substrate of the present invention comprising an insulating substrate, an active element disposed above the insulating substrate, a wiring line for supplying an electric signal or an driving electric power for driving the active element, and an insulating layer including an insulating material, the insulating material having a dielectric constant lower than that of the insulating substrate.

According to the invention, a parasitic capacitance generated between the electrodes or wiring lines can be reduced, since the insulating layer for insulating between the electrodes of the active element or between the wiring lines connected to the electrodes comprises an insulating material having a dielectric constant of a prescribed value or less. Consequently, the addressing signals supplied to the active element is securely isolated from each other to enable the active element to be precisely addressed. Reducing the parasitic capacitance also enables the active element to be operated by the addressing signals having a higher frequency. Examples of the active element include semiconductor elements such as a transistor and two terminal elements such as MIM (Metal-in-Metal liquid crystal).

The active element of the circuit substrate may be a transistor.

The dielectric constant of the insulating material of the circuit substrate is preferably 4 or less, more preferably 3 or less, and particularly 2.5 or less.

Preferably, the insulating material of the circuit substrate according to the invention comprises a porous material, aerogel, porous silica, magnesium fluoride, or a material containing these materials, a gel containing dispersed fine particles of magnesium fluoride, fluorinated polymer or a material containing the same, a porous polymer having a branched structure, a silica glass, a spin-on glass layer comprising at least one of alkyl siloxane polymer, alkyl silsesquioxane polymer, hydrogenated alkyl silsesquioxane polymer and polyalkyl ether, and a material containing at least one of inorganic fine particles and organic fine particles in a prescribed material.

Preferably, the circuit substrate according the invention comprises a protective layer formed so as to cover the active element.

Providing the protective layer so as to cover the active element protects the active element from deterioration caused by invasion of metallic components, gases in the atmosphere and moisture.

Preferably, the protective layer of the circuit substrate according to the invention comprises a material containing at least one of a drying agent and a chemical adsorbent; a material containing at least one of a ceramic, silicon nitride, silicon oxide nitride and silicon oxide; a material containing at least one of boron, carbon and nitrogen, and at least one of aluminum, phosphorous and silicon; a material containing at least one of cerium, ytterbium, samarium, erbium, yttrium, lanthanum, gadolinium, dysprosium and neodymium, and aluminum, silicon, nitrogen and oxygen; and a material containing at least one of barium oxide, calcium oxide, activated carbon and zeolite.

The invention provides an electro-optical device comprising an electro-optical element interposed between a cathode and an anode and disposed on the substrate,

wherein an insulating layer comprising an insulating material having a dielectric constant of a prescribed value or less is disposed between at least one of the cathode and anode and the substrate.

According to the invention, the parasitic capacitance generated between the electrodes can be reduced, since the insulating layer comprising the insulating material having a dielectric constant of a prescribed value or less is interposed between at least one of the cathode and anode interposing the electro-optical element and the substrate. Consequently, the addressing signals supplied to the active element is securely isolated from each other to enable the active element to be precisely addressed. Reducing the parasitic capacitance also enables the active element to be operated by the addressing signals having a higher frequency. The addressing method of the electro-optical device available include either a passive addressing method or an active addressing method. Examples of the electro-optical device include an organic EL element, an inorganic EL element, a liquid crystal element, an electrophoresis element, a laser diode and an electron emitting element.

Preferably, the electro-optical device of the invention contains an active element for addressing the electro-optical element.

According to the invention, an active matrix electro-optical device may be constructed using the active element to enable the electro-optical device to be more bright and excellent in response performance. Examples of the active element include a semiconductor device and two terminal element such as MIM.

Preferably, the substrate of the electro-optical device comprises an insulating material. Preferably, the active element of the electro-optical device is a transistor.

The dielectric constant of the insulating layer of the electro-optical device is preferably 4 or less, more preferably 3 or less and particularly 2.5 or less.

Preferably, the insulating material of the electro-optical device comprises a porous material, aerogel, porous silica, magnesium fluoride, or a material containing these materials, a gel containing dispersed fine particles of magnesium fluoride, fluorinated polymer or a material containing the same, a porous polymer having a branched structure, a silica glass, a spin-on glass layer comprising at least one of alkyl siloxane polymer, alkyl silsesquioxane polymer, hydrogenated alkyl silsesquioxane polymer and polyalkyl ether, and a material containing at least one of inorganic fine particles and organic fine particles in a prescribed material.

Preferably, the electro-optical device according the invention comprises a first protective layer formed so as to cover the active element.

The active element may be protected from deterioration by blocking metallic component, gases in the atmosphere and moisture from invading from the outside of the active element thanks to the first protective layer formed so as to cover the active element.

Preferably, electro-optical device according the invention also comprises a second protective layer formed so as to cover the cathode.

The active element may be protected from deterioration by blocking metallic component, gases in the atmosphere and moisture from invading from the outside of the active element thanks to the second protective layer formed so as to cover surface of the cathode.

At least one of the first and second protective layers of the electro-optical device according to the invention comprises a material containing at least one of the drying agent and chemical adsorbent; a material containing at least one of ceramic, silicon nitride, silicon oxide nitride and silicon oxide; a material containing at least one of boron, carbon and nitrogen and at least one of aluminum, phosphorous and silicon; a material containing at least one of gadolinium, cerium, ytterbium, samarium, erbium, yttrium, lanthanum, dysprosium and neodymium, and aluminum, silicon, nitrogen and oxygen; or at least one of barium oxide, calcium oxide, activated carbon and zeolite.

Preferably, the electro-optical element of the electro-optical device of the invention is an organic electroluminescence element.

According to the invention, using the organic electroluminescence element as the electro-optical element enables a display that is not restricted by a low addressing voltage and a limited angle of vision to be obtained.

The electronic appliances of the invention preferably comprises the circuit substrate or electro-optical device as described above.

The invention provides electronic appliances that display a stable image with no delay to high frequency input signals by reducing the parasitic capacitance.

Embodiments of the present invention will now be described by way of further example only and with reference to the accompanying drawings, in which:-

Fig. 1 illustrates the construction of the electro-optical device according to the invention applied to an organic EL display.

Fig. 2 is a magnified plane view of the pixel in the display device in Fig. 1.

Fig. 3 shows across section of the electro-optical device of the invention along the line A-A in Fig. 2.

Fig. 4 shows an example of electronic appliances comprising the electro-optical device according to the invention.

Fig. 5 shows an example of electronic appliances comprising the electro-optical device according to the invention.
Fig. 6 shows an example of electronic appliances comprising the electro-optical device according to the invention.

An embodiment of the present invention will be further illustrated with reference to the drawings.

Fig. 1 illustrates a plane view of the wiring structure of the electro-optical device that is suitable as the display in the embodiment of the invention.

The electro-optical device of this embodiment is an active matrix organic EL display using a thin film transistor (abbreviated as TFT hereinafter) and an organic electroluminescence element (abbreviated as EL element hereinafter) as an active element and electro-optical element, respectively.

In this drawing, the electro-optical device 1 comprises a plurality of scanning lines 131 (wiring lines), a plurality of signal lines 132 (wiring lines) extending in the direction perpendicular to the scanning line 131, and a power lines 133 for light emission extending in the direction parallel to the signal lines 132, and pixel regions A(AR) are provided at respective cross points between the scanning lines 131 and signal lines 132.

A data line addressing circuit 90 comprising a shift resistor, level shifter, video line and analogue switch is connected to each signal line 132. A scanning line addressing circuit 80 comprising a shift resistor and level shifter is connected, on the other hand, to each scanning line 131.

Each pixel region A comprises a switching TFT 22 for supplying a scanning signal to a gate electrode through the scanning line 131, a capacitor <u>cap</u> for retaining an image signal supplied from the signal line 132 through the switching TFT 22, a current TFT 24 for supplying the image signal retained in the capacitor <u>cap</u> to a gate electrode, a pixel electrode 23 (an anode) in which an addressing current flows from the power line 133 for light emission when electrically connected to the power line 133 through the current TFT 24, and an organic EL element 3 interposed between the pixel electrode 23 and cathode 222.

In the electro-optical device having the construction as described above, the potential of the signal line 132 is retained in the capacitor <u>cap</u> when the TFT 22 is turned on by being addressed with the scanning line 131, and electrical continuity of the TFT 24 is determined depending on the electric charge retained on the capacitor cap. An addressing electric current flows and is supplied to the organic EL element 3 from the power line 133 for light emission through the pixel electrode 23 depending on electrical continuity of the current TFT. The luminous intensity of the organic EL element 3 is determined by the intensity of the electric current supplied to the organic EL element 3.

Fig. 2 shows a magnified plane view of the pixel region A when the cathode 222 and organic EL element 3 are removed. In the drawing, four edges of the pixel electrode 23 having a rectangular plane view are surrounded by the scanning line 131, signal line 132, power line 133 for light emission and scanning line 131 belonging to another pixel electrode. The shape of the pixel electrode 23 is not necessarily a rectangle, and other shapes may be available. For example, the shape of the pixel electrode 23 is preferably a circle or ellipsoid having rounded corners in order to uniformly form luminous layers constituting the organic EL element and charge transfer layers such as electron or positive hole transfer layers on the pixel electrode using a liquid process such as an ink-jet method.

The cross sectional structure of the electro-optical device 1 will be described below with reference to Fig. 3.

Fig. 3 shows a cross section along the line A-A in Fig. 2. In the drawing, the electro-optical device 1 comprises a substrate 2, a pixel electrode 23 made of a transparent electrode material such as indium tin oxide (ITO), an organic EL element 3 disposed on the pixel electrode 23, a cathode 222 disposed so as to interpose the organic EL element 3 on the pixel electrode 23, and a current TFT 24, which serves as an electric current control member for controlling the electric current to the pixel electrode 23, formed on the substrate 2. A seal layer 20 (a second protective layer) is further provided on the surface of the cathode 222. The cathode 222 is made of at least a metal selected from aluminum (Al), magnesium (Mg), gold (Au), silver (Ag) and calcium (Ca). An alloy or a laminate of the metals described above is also used for the cathode 222. The current TFT 24 is operated based on operation instruction signals from the scanning line addressing circuit 80 and data line addressing circuit 90, and controls the electric current to the pixel electrode 23.

The organic EL element 3 mainly comprises a positive hole transfer layer 70 that is able to transfer positive holes from the anode 23, a luminous layer 60 containing an organic EL substance as one of electro-optical substances, and an electron transfer layer 50 provided on the surface of the luminous layer 60. The cathode (an opposed electrode) 222 is provided on the surface of the electron transfer layer.

A TFT 24 is provided on the surface of the substrate 2 with interposition of a protective underlayer 281 mainly comprising $SiO_2$. The TFT 24 comprises a silicon layer 241 formed on the surface of the protective underlayer 281, a gate insulating layer 282 provided on the surface of the protective underlayer 281 so as to cover the silicon layer 241, a gate electrode 242 provided at a portion facing the silicon layer 241 of the gate insulating layer 282, a first interlayer insulating layer 283 (an insulating layer) provided on the surface of the gate insulating layer 282 so as to cover the gate electrode 242, a source electrode 243 connected to the silicon layer 241 through a contact hole opening from the gate insulating layer 282 trough the first interlayer insulating layer 283a drain electrode 244 connected to the silicon layer 241 through a contact hole, which is provided at a position facing the source electrode 243 with interposition of

the gate electrode 242 and is open from the gate insulating layer 282 through the first interlayer insulating layer 283, a barrier layer 285 (a protective layer or a first protective layer) provided on the surface of the first interlayer. insulating layer 283 so as to cover the source electrode 243 and drain electrode 244, and a second interlayer insulating layer 284 (insulating layer) provided on the surface of the barrier layer.

The pixel electrode 23 is disposed on the surface of the second interlayer insulating layer 284, and the pixel electrode 23 and drain electrode 244 are connected with each other through a contact hole 23a opening from the second interlayer insulating layer 284 through the barrier layer 285. A third insulating layer 221 made of a synthetic resin is provided between a portion of the surface of the second interlayer insulating layer 284 except the portion having the organic EL element and the cathode 222.

The region of the silicon layer 241 overlapping the gate electrode 242 with interposition of the gate insulating layer 282 serves as a channel region. A source region is provided at the source side of the channel region of the silicon layer 241, while a drain region is provided at the drain side of the channel region. The source region is connected to the source electrode 243 through a contact hole opening from the gate insulating layer 282 through the first interlayer insulating layer 283. The drain region is connected, on the other hand, to the drain electrode 244 provided on the same level as the source electrode 243 through a contact hole opening from the gate insulating layer 282 through the first interlayer insulating layer 283. The pixel electrode 23 is connected to the drain region of the silicon layer 241 through the drain electrode 244.

While the material to be used for the substrate 2 is not particularly restricted, a light-transmissible transparent or semi-transparent material such as a transparent glass, quartz, sapphire, or a transparent synthetic resin such as polyester, polyacrylate, polycarbonate or polyether ketone is used, since the emitted light from the luminous layer 60 is projected out of the substrate 2 side having the TFT 24 in this embodiment. A cheap soda glass is favorably used as the material for forming the substrate 2. Preferably, a silica coat is provided on the soda glass, since it is effective for protecting the soda glass that is susceptible to an acid and alkali while being effective for planarizing the surface of the substrate 2.

The luminous color may be controlled by providing a color conversion layer having a color filter layer or luminous substance on the substrate 2, or by providing a dielectric reflection layer.

When the electro-optical device is constructed so that the emitted light is projected out of the side opposed to the substrate 2 having the TFT 22 (a top emission electro-optical device), on the other hand, the substrate may be opaque. In this case, a ceramic such as alumina, a metal sheet such as a stainless sheet subjected to an insulation treatment such as surface oxidation, and a thermosetting or thermoplastic resin may be used.

A silicon oxide layer with a thickness of about 200 to 500 nm as the protective underlayer 281 is formed by a CVD method using TEOS (tetraethoxy silane) and oxygen gas as starting materials for providing the protective underlayer 281 on the substrate 2.

For forming the silicon layer 241, the substrate 2 is heated at about 350°C, and an amorphous silicon layer with a thickness of about 30 to 70 nm is deposited on the surface of the protective underlayer 281 by plasma CVD or ICVD. Subsequently, the amorphous silicon layer is crystallized by laser annealing, rapid heating or solid phase crystal growth to turn the amorphous silicon layer into a polysilicon layer. A line beam of an eximer laser with a major beam length of 400 mm is used in the laser annealing method, and the output energy thereof is controlled, for example, to 200 $mJ/cm^2$.

The line beam is scanned so that the portion of the laser beam corresponding to 90% of the laser peak intensity overlaps each region in the minor axis direction. Then, the polysilicon layer is patterned by photolithography to form islets of the silicon layer 241.

While the silicon layer 241 serves as the channel region and source/drain region of the current TFT 24, a semiconductor layer that serves as the channel region and source/drain region of the switching TFT 22 is also formed on a different cross section. In other words, while two kinds of TFTs 22 and 24 are simultaneously formed, they are deposited by the same procedure. Accordingly, only the current TFT 24 is described with respect to the TFTs, and descriptions of the switching TFT are omitted hereinafter.

The gate insulating layer 282 comprising a silicon oxide layer or a silicon nitride layer with a thickness of about 60 to 150 nm is formed by deposition on the surface of the silicon layer 241 by the plasma CVD method using TEOS and oxygen gas as starting materials. A dielectric material having a large dielectric constant is preferable as the material of the gate insulating layer 282.

The gate electrode 242 is formed by depositing a conductive layer comprising a metal such as aluminum, tantalum, molybdenum, titanium or tungsten on the gate insulating layer 282, followed by patterning the layer.

For forming the source region and drain region in the silicon layer 241, the gate electrode 242 is formed at first, and the gate electrode 242 is used as a patterning mask for injecting phosphor ions. Consequently, high concentration impurities are introduced into the gate electrode 242 in a self-aligning manner, and the source and drain regions are formed in the silicon layer 241. The portion where no impurities have not been introduced serve as the channel region.

The first interlayer insulating layer 283 is a low dielectric constant layer comprising a low dielectric constant material having a lower dielectric constant than the conventional silicon oxide layer ($SiO_2$ layer: dielectric constant = about 4), and is formed on the surface of the gate electrode 282.

Examples of the material for forming the first interlayer insulating layer 283 include a porous material, aerogel, porous silica, magnesium fluoride, fluorinated polymer and porous polymer. For example, the first interlayer insulating layer 283 comprising the porous $SiO_2$ layer is formed by the CVD method (chemical vapor deposition method) using $Si_2H_6$ and $O_3$ as reaction gases. Large particles of $SiO_2$ are formed in the vapor phase using these reaction gases, and deposit on the gate insulating layer 282. Consequently, many voids are formed in the first interlayer insulating layer 283 as a porous material, and the first interlayer insulating layer 283 becomes a porous layer having a low dielectric constant.

A hydrogen plasma treatment may be applied on the surface of the first interlayer insulating layer 283. As a result, dangling bonds in Si-O bonds on the surface of the voids are replaced with Si-H bonds to improve the anti-hygroscopic property of the layer. A different $SiO_2$ layer may be provided on the first interlayer insulating layer 283 after the plasma treatment.

The reaction gases comprising $Si_2H_6$ and $O_2$, $Si_3H_8$ and $O_3$, and $Si_3H_8$ and $O_2$ as well as $Si_2H_6$ and $O_3$ may be used for forming the first interlayer insulating layer 283 by the CVD method. Reaction gases containing B (boron) or F (fluorine) may be used in addition to the reaction gases above.

The first interlayer insulating layer 283 as a porous layer having a stable layer quality may be formed by laminating a porous $SiO_2$ layer and a $SiO_2$ layer deposited by the conventional vacuum chemical vapor deposition method. These layers can be laminated by intermittently or periodically generating a plasma in an atmosphere of $SiH_4$ and $O_2$ under a reduced pressure. For depositing the first interlayer insulating layer 283, for example, the substrate 2 is placed in a given chamber, and an RF voltage (a high frequency voltage) is applied to the chamber using $SiH_4$ and $O_2$ as the reaction gases while maintaining the temperature in the chamber at 400°C. While the flow rates of the $SiH_4$ and $O_2$ gases are kept constant, the RF voltage is applied to the chamber at a frequency of 10 seconds, thereby allowing the plasma to be generated and extinguished at a frequency of 10 seconds. A process using the vacuum CVD method and a process using the plasma CVD method can be repeatedly applied in one chamber using the plasma that changes in a time dependent manner. Repeating the vacuum CVD method and vacuum plasma CVD method permits the $SiO_2$ layer having many voids in the layer to be formed, thereby enabling the first interlayer insulating layer 283 to be porous.

The first interlayer insulating layer 293 may be constructed with an aerogel. The aerogel is a light-permeable porous substance having a uniform super-fine structure, which is obtained by drying a swelled gel formed by a sol-gel reaction of a metal alkoxide under a supercritical condition. Examples of the aerogel include silica aerogel and an aerogel mainly comprise alumina. The silica aerogel comprises 90% by volume or more of voids with a balance of SiO2 fine particles with a particle size of several tens nanometers that are a dendritic coagulated solid. The silica aerogel having such high void ratio is effective as a low dielectric constant material.

The silica aerogel is produced by the steps of producing a swelled gel by the sol-gel method, aging the swelled gel, and obtaining the aerogel by supercritical drying of the swelled gel. The supercritical drying method is suitable for drying the gel without shrinkage by replacing a fluid in a jelly of a gel material with a supercritical fluid followed by removing the supercritical fluid. An aerogel having a high void ratio can be obtained by this method.

When the first interlayer insulating layer 283 is formed of the silica aerogel, the swelled gel as a starting material of the aerogel is coated on the gate insulating layer 282 by a spin-coating method, followed by supercritical drying. The solvent in the swelled gel is removed by replacing it with a supercritical fluid in the supercritical drying method using the supercritical fluid. Examples of the supercritical fluid available include carbon dioxide ($CO_2$), alcohols such as methanol, ethanol, isopropanol, isobutanol and cyclohexanol, $NH_3$, $H_2O$, $N_2O$, methane, ethane, ethylene, propane, pentane, cyclotrifluoromethane and monofluoromethane.

While the low dielectric constant layer is formed using the silica aerogel prepared by supercritical drying after coating the swelled gel on the substrate by spin-coating, a synthetic resin (an organic substance) may be mixed with the swelled gel. The synthetic resin available has a heat-denaturation temperature of higher than the critical temperature of the supercritical fluid and is light-permeable. When alcohols are used as the supercritical fluid, examples of the synthetic resin, which has a heat-denaturation temperature of higher than the critical temperature of the supercritical fluid and being light-permeable, include hydroxypropyl cellulose (HPC), polyvinyl butyral (PVB) and ethyl cellulose (EC), wherein PVB and EC are soluble in alcohols and insoluble in water. It is desirable to select a resin such as a chlorinated polyethylene when ether is used as the supercritical solvent, and to select HPC when CO2 is used as the supercritical solvent.

The low dielectric constant layer may be the silica aerogel as well as an aerogel mainly comprising alumina having a lower dielectric constant, which is a porous material having a dielectric constant lower than conventional silicon oxide layers ($SiO_2$ layer, dielectric constant = 4).

The materials available for the low dielectric constant layers include porous silica, magnesium fluoride or a

material containing these materials. The low dielectric layer comprising magnesium fluoride may be formed by sputtering, or may be formed of a gel in which fine particles of magnesium fluoride are dispersed. The low dielectric constant material may also comprise a fluorinated polymer or a material containing the same such as, for example, perfluoroalkyl polyether, perfluoroalkyl amine or a mixed film of perfluoroalkyl polyether and perfluoroalkyl amine.

Otherwise, the low dielectric constant layer may be silica glass or a spin-on-glass (SGO) layer of alkylsiloxane polymer, alkyl silsesquioxane polymer and hydrogenated alkyl silsesquioxane polymer. Or, it may be an organic polymer such as a polyarylether layer, diamond layer or fluorinated amorphous carbon layer. The low dielectric constant layer of the spin-on glass film can be prepared by coating a material of the spin-on glass layer by spin-coating using an alcohol as a solvent, and by allowing the solvent to evaporate by a heat treatment. The supercritical drying method may be also employed for forming the spin-on glass layer. Using the supercritical drying method permits coverage and film quality to be further improved.

A fluorocarbon compound that is dispersible or soluble in a solvent may be mixed with a polymer binder for preparing the low dielectric constant layer.

Examples of the polymer binder include polyvinyl alcohol, polyacrylic acid, polyvinyl pyrrolidone, sodium polyvinyl sulfonate, polyvinyl methylether, polyethylene glycol, poly-$\alpha$-trifluoromethyl acrylate, polyvinyl methylether-co-maleic anhydride, polyethyleneglycol-co-propylene glycol and polymethacrylic acid.

Examples of the fluorocarbon compound include ammonium perfluorooctanate, tetramethylammonium perfluorooctanate, C-7 and C-10 ammonium perfluoroalkyl sulfonate, C-7 and C-10 tetramethylammonium perfluoroalkyl sulfonate, fluorinated alkyl quaternary ammonium iodide, perfluoroadipic acid and quaternary ammonium perfluoroadipate.

Since a method for introducing voids is effective for preparing the low dielectric constant layer, micro-voids may be formed among the fine particles or in the fine particles in addition to the aerogel as described above. Inorganic or organic fine particles may be used for the low dielectric constant layer.

The inorganic fine particles are preferably amorphous. The inorganic fine particles preferably comprise metal oxides, nitrides, sulfides or halides, more preferably metal oxides or halides, and most preferably metal oxides or metal fluorides. Examples of the preferable metals include Na, K, Mg, Ca, Ba, Al, Zn, Fe, Cu, Ti, Sn, In, W, Y, Sb, Mn, Ga, V, Nb, Ta, Ag, Si, B, Bi, Mo, Ce, Cd, Be, Pb and Ni, and Mg, Ca, B and Si are more preferable. Inorganic compounds containing two kinds of the metals may be used, and silicon oxide or silica is a particularly preferable inorganic compound.

Micro-voids in the inorganic fine particles may be formed by cross-linking silica molecules forming the particles. The volume of the particles is contracted by cross-linking the silica molecules, and the particle becomes porous. The (porous) inorganic fine particles containing the micro-voids can be directly synthesized as a dispersion by sol-gel methods (Japanese Unexamined Patent Application Publication No. 53-112732 and Japanese Patent Publication No. 57-9051), or by precipitation methods (APPLIED OPTICS, 27, p3356, 1988). A dispersion may be also obtained by mechanically pulverizing a powder obtained by a drying and precipitation method. Otherwise, commercially available porous inorganic fine particles (for example silicon dioxide gel) may be used.

It is also preferable that the organic fine particles are amorphous. The organic fine particles are preferably polymer fine particles synthesized by polymerization of monomers (for example emulsion polymerization). The polymer of the organic fine particles preferably contains fluorine atoms. Examples of the monomer used for synthesizing the fluorine containing polymer and containing the fluorine atoms include fluoroethylenes (fluoroethylene, vinylidene fluoride, tetrafluoroethylene, hexafluoropropylene and perfluoro-2,2-dimethyl-1,3-dioxol), fluorinated alkyl esters of acrylic acid or methacrylic acid, and fluorinated vinylethers. A copolymer of a monomer containing the fluorine atoms and a monomer containing no fluorine atom may be used. Examples of the monomer containing no fluorine atom include olefins (ethylene, propylene, isoprene, vinyl chloride and vinylidene chloride), acrylic esters (methyl acrylate, ethyl acrylate and 2-ethylhexyl acrylate), methacrylic acid esters (methyl methacrylate, ethyl methacrylate and butyl methacrylate), styrenes (styrene, vinyltoluene and $\alpha$-methylstyrene), vinylethers (methylvinyl ether), vinyl esters (vinyl acetate and vinyl propionate), acrylamides (N-tert-butyl acrylamide and N-cyclohexyl acrylamide), methacrylamides and acrylonitriles.

The micro-voids in the organic fine particles can be formed, for example, by cross-linking of the polymer for forming the particles. The volume of the particles contracts by cross-linking of the polymer to form porous particles. The monomers for synthesizing the polymer preferably contain 20 mol% or more of functional monomers for cross-linking the polymer for forming the particles. The proportion of the functional monomers is more preferably 30 to 80 mol%, most preferably 35 to 50 mol%. Examples of the functional monomer include dienes (butadiene and pentadiene), esters of polyfunctional alcohols and acrylic acid (ethyleneglycol diacrylate, 1,4-cyclohexane diacrylate and dipentaerythritol hexaacrylate), esters of polyfunctional alcohols and methacrylic acid (ethyleneglycol dimethacrylate, 1,2,4-cyclohexane tetranethacrylate and pentaerythritol tetramethacrylate), divinyl compounds (divinyl cyclohexane and 1,4-divinylbenzene), divinyl sulfone, bisacrylamides (methylene bisacrylamide) and bismethacrylamides. The micro-voids among the particles may be formed by stacking at least two fine-particles.

The low dielectric constant layer may comprise a material containing fine voids and inorganic fine particles. The low dielectric constant layer is formed by coating, wherein the micro-voids are formed by eliminating a gas from the layer by an active gas treatment after coating. Otherwise, two or more kinds of superfine particles (for example $MgF_2$ and $SiO_2$ particles) may be mixed together, and the low dielectric constant layer is formed by changing the mixing ratio in the direction of thickness. The dielectric constant is varied by changing the mixing ratio. The superfine particles are bonded with each other with $SiO_2$ formed by heat decomposition of ethyl silicate. Carbon dioxide and water vapor are also generated by combustion of ethyl moieties during heat decomposition of ethyl silicate. Spaces are formed among the superfine particles by elimination of carbon dioxide and water vapor. Otherwise, the low dielectric constant layer may be formed by allowing an inorganic fine power comprising porous silica and a binder to be used, or may be formed by forming the voids among the fine particles by stacking at least two fine particles comprising the fluorinated polymer.

The void ratio may be improved by forming a branched structure. For example, the low dielectric constant may be obtained using a polymer having a branched structure such as a dendrimer.

For forming the source electrode 243 and drain electrode 244, contact holes corresponding to the source electrode and drain electrode are formed by patterning the first interlayer insulating layer 283 by photolithography at first. Then, after forming a conductive layer comprising a metal such aluminum, chromium or tantalum so as to cover the first interlayer insulating layer 283, a patterning mask is provided on the conductive layer so as to cover the region in which the source electrode and drain electrode are to be formed. The source electrode 243 and drain electrode 244 are formed by patterning the conductive layer.

The barrier layer 285 is provide for preventing metal ions from diffusing from the side contained in the organic EL element constituting the luminous layer 60 to the TFT 24 side. The barrier layer is formed by the same manner as forming the first interlayer insulating layer 283 so as to cover the source electrode 243 and drain electrode 244. Examples of the barrier layer 285 include an insulating layer containing at least one element selected from B (boron), C (carbon) and N (nitrogen), and an insulating layer containing at least one element selected from Al (aluminum), Si (silicon) and P (phosphorous).

For example, compounds available include a nitride of aluminum represented by aluminum nitride ($Al_xN_y$), a carbide of silicon represented by silicon carbide ($Si_xC_y$), a nitride of silicon represented by silicon nitride ($Si_xN_y$), a nitride of boron represented by boron nitride ($B_xN_y$), and a phosphide of phosphorous represented by boron phosphide ($B_xP_y$). An oxide of aluminum represented by aluminum oxide ($Al_xO_y$) is one of the preferable materials that can prevent the luminous element from being deteriorated by heat, since it is excellent in a heat dissipation effect with a heat conductivity of 20 $Wm^{-1}K^{-1}$. These materials have not only the effects as described above but also an effect for blocking moisture from invading.

Other elements may be combined with the compounds above. For example, aluminum nitride oxide may be used by adding nitrogen to aluminum oxide. This material also has not only the heat dissipating effect but also an effect for blocking moisture and mobile ions from invading.

An insulating layer containing Si, Al, N, O and M (M is at least one of rare earth elements, preferably Ce (cerium), Yb (ytterbium), Sm (samarium), Er (erbium), Y (yttrium), La (lanthanide), Gd (gadolinium), Dy (dysprosium) and Nd (neodymium)) may be used. These materials also have not only the heat dissipating effect but also an effect for blocking moisture and mobile ions from invading.

At least a carbon layer including a diamond thin layer or an amorphous carbon layer (particularly an amorphous carbon layer having characteristics resembling to those of diamond, which is called as diamond-like carbon) may be used. These materials have a so high heat conductivity that they are quite effective as the heat dissipating layer. However, since transmittance of the layer decreases due to a brownish color when the layer is too thick, it is preferable to use a layer as thin as possible (preferably 5 to 100 nm).

It is preferable that the effect of the protective layer for protecting the TFT from mobile ions and moisture is not compromised. Accordingly, while the thin layer comprising the material having the heat dissipating effect may be used by itself, it is effective to laminate the thin layer with an insulating layer that can block permeation of mobile ions and moisture (representative examples are a silicon nitride layer ($Si_xN_y$) and silicon nitride oxide layer ($SiO_xN_y$)).

The second interlayer insulating layer 284 also comprises a porous material, aerogel, porous silica, magnesium fluoride, fluorinated polymer and porous polymer as the first interlayer insulating layer 283 does, and is formed on the barrier layer 285 by the same procedure as forming the first interlayer insulating layer 283.

After forming the barrier layer 285 and second interlayer insulating layer 284, contact holes 23a are formed at the portions corresponding to respective drain electrodes 244.

The dielectric constant of the first interlayer insulating layer 283 and second interlayer insulating layer 284 is adjusted to be preferably 3 or less, more preferably to be 2.5 or less.

The anode 23 connected to the organic EL element 3 comprises a transparent electrode such as ITO, $SnO_2$ doped with fluorine, ZnO and polyamine, and is connected to the drain electrode 244 of TFT 24 through the contact hole 23a. For forming the anode 23, a layer comprising the transparent electrode material is formed on the second

interlayer insulating layer 284, followed by patterning the layer.

The third insulating layer 221 is composed of a synthetic resin such as an acrylic resin and a polyimide resin. The third insulating layer 221 is formed after forming the anode 23. For example, the third insulating layer 221 is formed by applying a solution of a resist such as the acrylic resin and polyimide resin in a solvent by spin-coating or dip coating. However, any materials for the insulating layer may be used, so long as they are insoluble in an ink solvent to be described hereinafter and readily patterned by etching. Subsequently, the third insulating layer 221 comprising an opening 221a is formed by forming the opening 221a by simultaneous etching of the insulating layers by photolithography.

A region exhibiting a liquidphile property (for example an ink-phile property) and a region exhibiting a liquid repelling property (for example an ink repelling property) are formed on the surface of the third insulating layer 221. Each region is formed by a plasma treatment in this embodiment. Actually, the plasma treatment comprises a preheating step, an ink-phile step for making the wall face of the opening 221a and electrode surface of the pixel electrode 23 ink-phile, an ink repelling step for making the surface of the third insulating layer 221 ink-repelling, and a cooling step.

The substrate (the substrate 2 including the third insulating layer) is heated at a prescribed temperature (for example about 70 to 80°C), and is subjected to an ink-phile step in which the substrate is treated with a plasma (for example an $O_2$ plasma treatment) in an atmosphere containing oxygen as a reaction gas. Subsequently, the substrate is subjected to an ink-repelling step in which the substrate is treated with a plasma (for example $CF_4$ plasma treatment) containing tetrefluoromethane as a reaction gas. The ink-phile property and ink repelling property are given to respective regions by cooling the substrate once heated for the plasma treatments. Although the electrode surface of the pixel electrode 23 is also a little affected by the $CF_4$ plasma treatment, hydroxyl groups introduced by the ink-phile treatment are not replaced with fluorine groups since ITO as the material of the pixel electrode 23 has little affinity to fluorine. Consequently, the ink-phile property of the pixel electrode can be maintained.

The positive hole transfer layer 70 is formed on the surface of the anode 23. The material for forming the positive hole transfer layer 70 is not particularly restricted, and any materials known in the art may be used. Examples of the material available include pyrazoline derivatives, arylamine derivatives, stilbene derivatives and triphenyldiamine derivatives. While examples of them include those disclosed in Japanese Unexamined Patent Application Publication Nos. 63-70257, 63-175860, 2-135359, 2-135361, 2-209988, 3-37992 and 3-152184, triphenyldiamine is preferable among them, and 4,4'-bis(N-(3-methylphenyl)-N-phenyamino)biphenyl is suitable among them.

The positive hole injection layer may be formed in place of the positive hole transfer layer, or both the positive hole injection layer and positive hole transfer layer may be formed together. While examples of the material for forming the positive hole injection layer include copper phthalocyanine (CuPc), polyphenylene vinylene such as polytetrahydrothiophenyl phenylene, 1,1-bis-(4-N,N-ditolylaminophenyl)cyclohexane and tris(8-hydroxyquinolinol)aluminum, copper phthalocyanine is preferably used.

The ink-jet method is used for forming the positive hole injection/transfer layer 70. The positive hole injection/transfer layer 70 is formed on the electrode 23 by discharging a composite ink containing a positive hole injection/transfer layer material on the anode 23 followed by drying and heat treatment. The step for forming the positive hole injection/transfer layer and steps thereafter are preferably performed in an inert gas atmosphere such as a nitrogen or argon atmosphere, in order to prevent the positive hole injection/transfer layer 70 and luminous layer 60 from being oxidized. For example, a composition containing the positive hole injection/transfer layer material is filled in an ink-jet head (not shown), discharge nozzles of the ink-jet head is made to face the electrode surface of the anode 23, and ink drops with a controlled volume per one drop are discharged on the electrode surface while allowing the ink-jet head to move relative to the substrate (substrate 2). Subsequently, a polar solvent contained in the composite ink is evaporated by drying the discharged ink drops to form the positive hole injection/transfer layer.

The composite ink available is prepared by dissolving s mixture of a polythiophene derivative such as polyethylene dioxythiophene and polystyrene sulfonic acid in a polar solvent such as isopropyl alcohol. The discharged ink drops are spread over the anode 23 that has been subjected to the ink-phile treatment, and are filled in the vicinity of the bottom of the opening 221a. The ink drops are repelled and do not adhere, on the other hand, on the surface of the third insulating layer 221 that has been subjected to the ink-repelling treatment. Consequently, the surface of the third insulating layer 221 is not damped with the ink drops even when the ink drops have missed to hit prescribed positions, and the repelled ink drops roll into the opening 221a on the third insulating layer 221.

The luminous layer 60 is formed on the positive hole injection/transfer layer 70. The materials for forming the luminous layer 60 are not particularly restricted, and include low molecular weight organic luminous pigments and luminous polymers, or luminous substances comprising various fluorescent substances and luminescent substances. Substances containing arylene-vinylene structures are particularly preferable among conjugated polymers that serve as the luminous substances. Examples of the low molecular weight fluorescent material include naphthalene derivatives, anthracene derivatives, perrylene derivatives, pigments such as polymethine, xanthene, coumarin and cyanine pigments, metal complexes of 8-hydroquinoline and derivatives thereof, aromatic amines, tetraphenyl cyclopentadiene derivatives, and substances known in the art disclosed in Japanese Unexamined Patent Application Publication Nos.

57-51781 and 59-194393.

While polymers having fluorescent groups in their side chains may be used when the fluorescent polymer is used as the material for forming the luminous layer 60, they preferably contain the conjugated structured in the main chain. Polythiophene, poly-p-phenylene, polyarylene vinylene and polyfluorene, and derivatives thereof are particularly preferable. Polyarylene vinylene and its derivative are preferable among them. Polyarylene vinylene and its derivative are polymers that contain 50 mol% or more of the repeating unit represented by the chemical formula (1) below in the total repeating units. It is further preferable that the repeating unit represented by the chemical formula (1) is 70 mol% or more of the total repeating units, although the proportion depends on the structure of the repeating unit.

$$-Ar-CR=CR'- \quad (1)$$

(Ar represents an arylene group or a heterocyclic group comprising 4 or more and 20 or less of carbon atoms concerned in the conjugate bonds; and R and R' independently represent a group selected from hydrogen, an alkyl group with a carbon number of 1 to 20, an aryl group with a carbon number of 6 to 20, a heterocyclic compound with a carbon number of 4 to 20, and a cyano group)

The fluorescent polymer may contain an aromatic group or its derivative, heterocyclic group or its derivative, and a group obtained as a combination of these groups as repeating units other than the repeating units represented by the chemical formula (1). The repeating unit represented by the chemical formula (1) and other repeating units may be linked with non-conjugate units comprising an ether group, amide group and imide group, or these conjugate units may be included in the repeating units.

The Ar group in the chemical formula (1) of the fluorescent polymer is an arylene group or heterocyclic group having the number of the carbon atoms related to the conjugate bonds of 4 or more and 20 or less. Examples of these groups include an aromatic group represented by the chemical formula (2) or its derivative, heterocyclic group or its derivative, and a group as a combination of these groups.

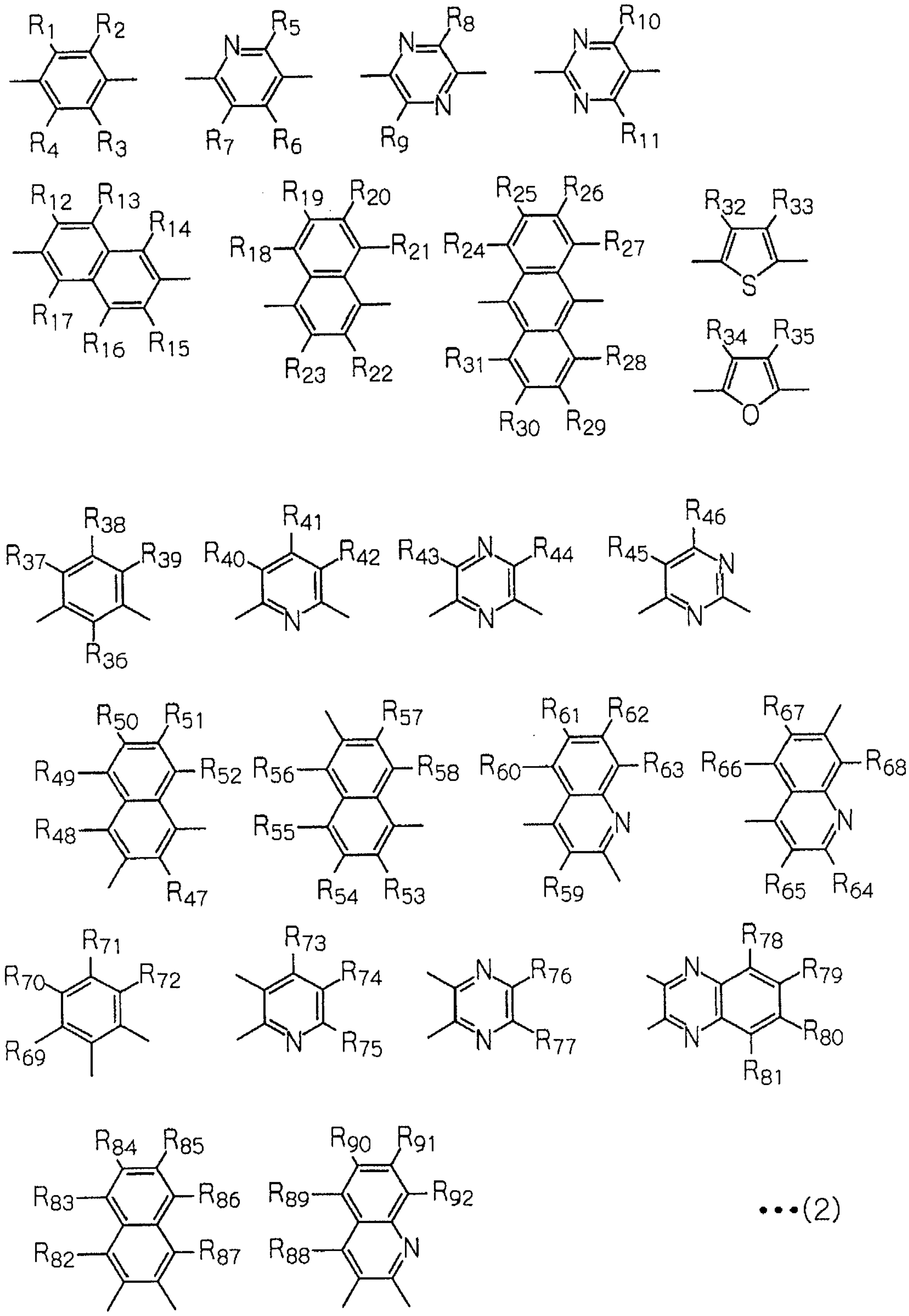

•••(2)

(R1 to R92 represent, each independently, a group selected from hydrogen, an alkyl group, alkoxy and alkylthio group with a carbon number of 1 to 20; aryl and aryloxy group with a carbon number of 6 to 18; and a heterocyclic group with a carbon number of 4 to 14)

Preferable groups among these groups are phenylene group, substituted phenylene group, biphenylene group, substituted biphenylene group, naphthalenediyl group, substituted naphthalenediyl group, anthracene-9,10-diyl group, substituted anthracene-9,10-diyl group, pyridine-2,5-diyl group, substituted pyridine-2,5-diyl group, thienylene group and substituted thienylene group. Phenylene group, biphenylene group, naphthalenediyl group, pyridine-2,5-diyl group and thienylene group are more preferable.

When R and R' in the chemical formula (1) are substituents other than hydrogen or cyano group, examples of the alkyl group with a carbon number of 1 to 20 include methyl group, ethyl group, propyl group, butyl group, pentyl group, hexyl group, heptyl group, octyl group, decyl group and lauryl group, and methyl group, ethyl group, pentyl group, hexyl group, heptyl group and octyl group are preferable among them. Examples of the aryl group include phenyl group, 4-C1 to C12-alkoxyphenyl group (C1 to C12 denote that the carbon number is 1 to 12), 4-C1 to C12-alkylphenyl group, 1-naphthyl group and 2-naphthyl group.

It is preferable from the view point of solubility in solvents that Ar in the chemical formula (1) has a group selected from at least one of the alkyl group, alkoxy group and alkylthio group with a carbon number of 4 to 20, aryl group and aryloxy group with a carbon number of 6 to 18, and heterocyclic group with a carbon number of 4 to 14.

Examples of these substituents include alkyl groups with a carbon number of 4 to 20 such as butyl group, pentyl group, hexyl group, heptyl group, octyl group, decyl group and lauryl group, and the pentyl group, hexyl group, heptyl group and octyl group are preferable. Examples of the alkoxy groups with a carbon number of 4 to 20 include butoxy group, pentyloxy group, hexyloxy group, heptyloxy group, octyloxy group, decyloxy group and lauryloxy group, and pentyloxy group, hexyloxy group, heptyloxy group and octyloxy group are preferable. Examples of the alkylthio group with a carbon number of 4 to 20 include butylthio group, pentylthio group, hexylthio group, heptylthio group, octylthio group, decyloxy group and lauryloxy group, and pentylthio group, hexylthio group, heptylthio group and octylthio group are preferable. Examples of the aryl group include phenyl group, 4-C1 to C12-alkoxyphenyl group, 4-C1 to C12-alkylphenyl group, 1-naphthyl group and 2-naphthyl group. Examples of the aryloxy group include phenoxy group. Examples of the heterocyclic group include 2-thyenyl group, 2-pyrrolyl group, 2-furyl group, and 2-, 3- or 4-pyridyl group. At least one of these substituents are preferably contained per molecular weight of 600 from the view point of obtaining a highly soluble fluorescent polymer, although the number of the substituents differs depending on the molecular weight and the number of the substituents of the fluorescent polymer.

The fluorescent polymer may be a random, block or graft copolymer, or a polymer having an intermediate structure thereof, for example a random copolymer partially containing block copolymer structures. The random copolymer partially containing block copolymer structures, or block or graft copolymer is preferable over the perfectly random copolymer from the view point of obtaining a fluorescent polymer exhibiting a high fluorescence quantum yield. Since the organic EL element formed in the invention takes advantage of a fluorescent light from a thin layer, the fluorescent polymer used should emit a fluorescent light in the solid state.

Examples of favorable solvents to be used for the fluorescent polymer include chloroform, methylene chloride, dichloroethane, tetrahydrofuran, toluene and xylene. The fluorescent polymer may be dissolved in these solvents in a concentration of 0.1 wt% or more, although the solubility depends on the structure and molecular weight of the fluorescent polymer.

The fluorescent polymer preferably has a molecular weight of $10^3$ to $10^7$ as converted into the molecular weight of polystyrene, and the degree of polymerization of the polymer varies depending on the structure of the repeating units and the proportion thereof. The total number of the repeating units is preferably 4 to 10,000, more preferably 5 to 3,000, and particularly 10 to 2,000 considering the film forming ability.

Although the methods for synthesizing these fluorescent polymers are not particularly restricted, Wittig reaction is an example of the synthetic method, wherein the fluorescent polymer is synthesized from a diphosphonium salt obtained by a reaction among a dialdehyde compound in which two aldehyde groups are bonded to an arylene group, a compound in which two halogenated methyl groups are bonded to an arylene group, and triphenylphosphine. Another example is a dehalogenation and hydration reaction of a compound in which two halogenated methyl groups are bonded to an arylene group. A further different example is a decomposition reaction of a sulfonium salt, wherein the fluorescent polymer is obtained by a heat treatment of an intermediate obtained by alkali polymerization of a sulfonium salt of a compound in which two halogenated methyl groups are bonded to an arylene group. The structure of the repeating units contained in the fluorescent polymer obtained can be changed in any of the synthetic methods by adding a compound having a molecular frame other than the arylene group, and by changing the proportion of the compound. Accordingly, the proportion of the compound to be added for copolymerization may be adjusted so that the content of the repeating units represented by the chemical formula (1) becomes 50 mol% or more. Wittig reaction is preferable among these synthetic methods considering reaction control and synthetic yield.

The synthetic method of an arylene-vinylene copolymer as an example of the fluorescent polymer will be described in detail hereinafter. For obtaining the fluorescent polymer by Wittig reaction, a bis(halogenated methyl) compound, for example 2,5-dioctyloxy-p-xylenne dibromide, is allowed to react with triphenylphosphine in N,N-dimethyl formamide to synthesize a phosphonium salt. The product is allowed to condense with a dialdehyde compound, for

example terephthalaldehyde, in ethyl alcohol using lithium ethoxide (Wittig reaction), thereby obtaining the fluorescent polymer containing the phenylene-vinylene group and 2,5-dioctyloxy-p-phenylene vinylene. At least two kinds of diphosphonium salts and/or at least two kinds of dialdehyde compounds may be involved in the reaction for obtaining a copolymer.

When the fluorescent polymer is used for the material for forming the luminous layer, the polymer is preferably purified by fractionation such as re-precipitation and chromatographic separation, since the purity of the polymer affects the luminous characteristics.

Three colors of red, green and blue luminous layer forming materials are used as the materials for forming the luminous layer comprising the fluorescent polymer for full color display. Each color material is injected to a pixel AR at a prescribed position using a patterning apparatus (ink jet apparatus).

A host material may be added to a guest material for the luminous substance.

Such luminous substance suitable for use comprises the host material such as organic polymer compounds and low molecular weight compounds, and guest material such as a fluorescent pigment or luminescent pigment that changes the luminous characteristics of the luminous layer.

When the solubility of the organic polymer compound is low, the luminous layer that serves as the organic EL layer of the conjugated polymer may be formed by heat-setting of the polymer as shown in the chemical formula (3) below after applying a precursor thereof. For example, in the case of a sulfonium salt as a precursor, the sulfonium group is eliminated by heat-treatment to form a conjugated organic polymer compound.

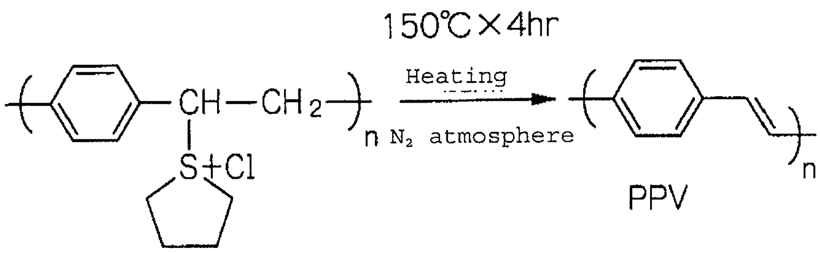


•••(3)

A highly soluble material may be directly coated, and the luminous layer can be obtained by removing the solvent.

The organic polymer compound emits a strong fluorescence light in a solid state that is able to form a uniform solid ultra-thin layer. Furthermore, the polymer has good film forming ability with tight adhesion to the ITO electrode while forming a tight conjugated polymer layer after curing.

An example of the preferable organic polymer compound is polyarylene-vinylene copolymer. The copolymer is soluble in aqueous solvents as well as organic solvents to facilitate preparation of a coating solution for applying to the second substrate 11. Furthermore, an optically high quality thin layer may be obtained since the polymer is obtained under a prescribed condition.

Examples of polyaryllene-vinylene include PPV derivatives such as PPV (poly(paraphenylenevinylene)), MO-PPV (poly(2,5-dimethoxy-1,4-phenylenevinylene)), CN-PPV (poly(2,5-bishexyloxy-1,4-phenylene-(1-cyanovinylene))), MEH-PPV (poly[2-methoxy-5-(2'-ethylhexyloxy)]-para-phenylenevinylene); poly(alkylthiophene) such as PTV (poly(2,5-thienylennevinylene)); PFV (poly(2,5-furylenevinylene)); poly(paraphenylene); and polyalkylfluorene. The compounds comprising PPV as shown by the chemical formula (4) or PPV derivatives, and polyalkylfluorenne as shown by the chemical formula (5) (for example polyalkylfluorene copolymer as shown by the chemical formula (6)) are particularly preferable among them.

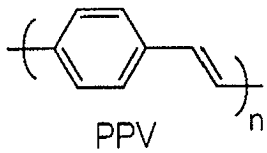

PPV

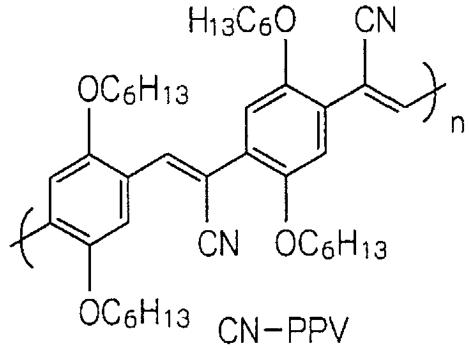

CN−PPV

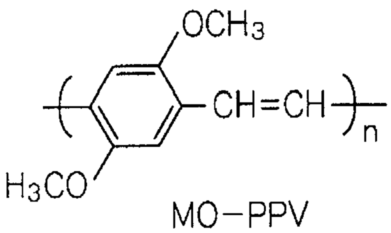

MO−PPV

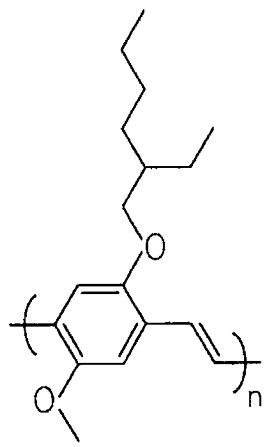

MEH−PPV

•••(4)

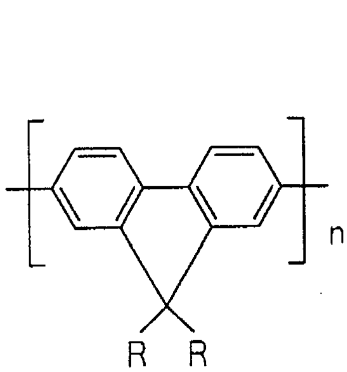

PAF

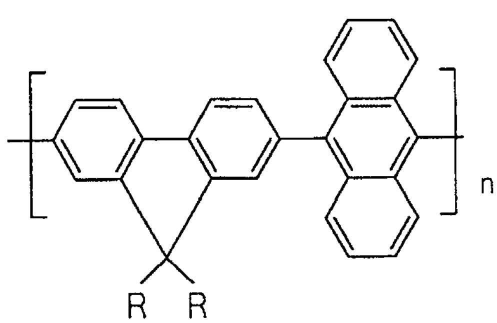

PAF−copolymer

•••(5)

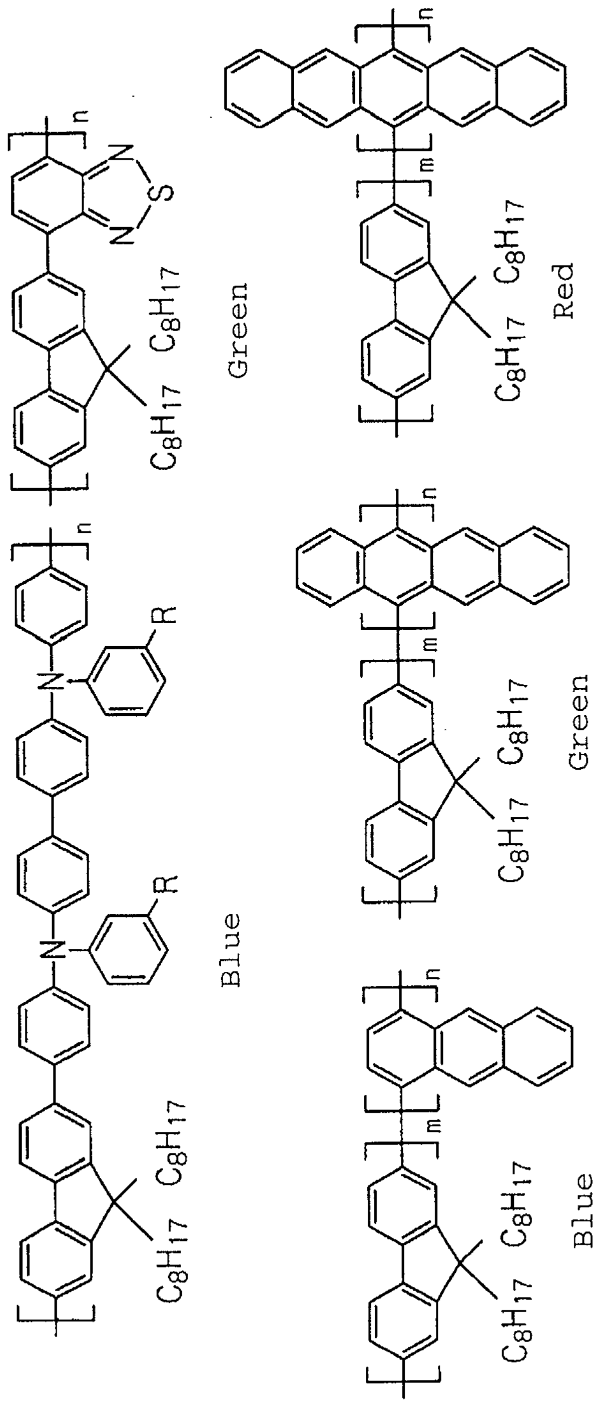

Blue

Green

Blue

Green

Red

Polyfluorene Copolymers

•••(6)

Since PPV emits a strong fluorescence light and is a conductive polymer in which π-electrons forming the double bonds are localized on the polymer chain, a high performance organic EL element may be obtained.

Examples of the organic polymer compounds that are able to form the luminous layer other than the PPV thin layer, and low molecular weight substances, or a material that is used for the host material in this embodiment, include

an aluminum quinolinol complex and distyryl biphenyl as well as BeBq2 and $Zn(OXZ)_2$ shown by the chemical formula (7), and conventional compounds such as TPD, ALO and DPVBi, in addition to a pyrrazoline dimer, quinoline dicarboxylic acid, benzopirrylium perchlorate, benzopyranoquinolidine, rubren and phenanthrone europium complex. One or at least two of these compounds may be used for the composition for the organic EL element.

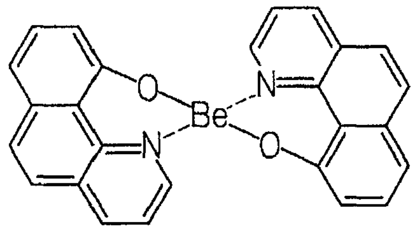

$BeBq_2$

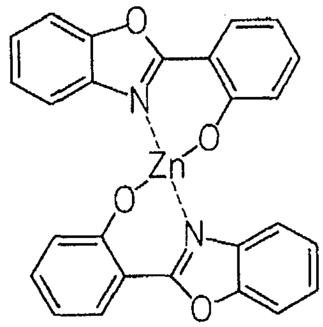

$Zn(OXZ)_2$

•••(7)

The guest material to be added to the host material include the fluorescent pigments and luminescent substances as described above. The fluorescent pigment is particularly effective for improving luminous efficiency of the luminous layer and for changing the maximum light absorption wavelength (luminous color), since it is able to change the luminous characteristics of the luminous layer. In other words, the fluorescent pigment may be used not only as a luminous layer material, but also as a pigment material that is responsible for a luminous function itself. For example, the energy of excitons generated by carrier re-combination on the conjugated organic polymer compound may be transferred onto the fluorescent pigment molecules. Since the light is emitted only from the fluorescent pigment molecules having a high fluorescence quantum yield, the current quantum efficiency of the luminous layer is also enhanced. Accordingly, adding the fluorescent pigment to the luminous layer is effective for changing the luminous color, since the luminous spectrum of the luminous layer coincides with the luminous spectrum of the fluorescent molecules by adding the fluorescent pigment in the fluorescent layer forming material.

The current quantum efficiency as used herein refers to a measure for considering luminous performance based on the luminous functions, and is defined by the following equation.

$$\eta E = \text{(energy of emitted photon)/(input electric energy)}$$

The luminous layer can emit three primary colors of red, green and blue by converting the maximum light absorption wavelength by doping the fluorescent pigments to enable a full color display to be obtained.

The luminous efficiency of the organic EL element can be largely improved by doping the fluorescent pigment.

When a luminous layer emitting a red light is formed, the preferable fluorescent pigments include DCM-1 as a laser pigment, or rhodamine or rhodamine derivatives, and penylene. The luminous layer may be formed by doping these fluorescent pigments in a host material such as PPV. However, since most of these fluorescent pigments are soluble in water, a more uniform luminous layer can be formed by doping a sulfonium salt as an water soluble PPV precursor followed by a heat treatment. Examples of such fluorescent pigments include rhodamine B, rhodamine B base, rhodamine 6G and rhodamine 101 perchlorate, and at least two of them may be mixed for use.

Quinaqulidone, ruburen, DCJT and its derivative are preferably used for forming a luminous layer that emits a green light. The luminous layer may be formed by doping these fluorescent pigments in a host material such as PPV as in the fluorescent pigment as described above. However, since most of these fluorescent pigments are also soluble in water, a more uniform luminous layer can be formed by doping a sulfonium salt as an water soluble PPV precursor followed by a heat treatment.

Distyryl biphenyl and its derivative are preferably used for forming a luminous layer that emits a blue light. The luminous layer may be formed by doping these fluorescent pigments in a host material such as PPV as in the fluorescent pigment described above. However, since most of these fluorescent pigments are also soluble in water, a more uniform luminous layer can be formed by doping a sulfonium salt as an water soluble PPV precursor followed by a heat treatment.

Examples of other fluorescent pigments that emits a blue light include coumarin and its derivative. These fluorescent pigments have so good compatibility with PPV that the luminous layer is readily formed. While coumarin itself is insoluble in solvents, solubility thereof is increased by appropriately selecting the substituents to render it soluble in the solvents. Examples of such fluorescent pigments include coumarine-1, coumarin-6, coumarin-7, coumarin-120, coumarin-138, coumarin-152, coumarin-153, coumarin-311, coumarin-314, coumarin-334, coumarin-337 and coumarin-343.

Examples of other fluorescent pigments that emit a blue light include tetraphenyl butadiene (TPB) or TPB derivatives and DPVBi. These fluorescent pigments are also soluble in water as are the red fluorescent pigments, and the luminous layer is readily formed since it has good compatibility with PPV.

One kind each or at least two kinds of the foregoing fluorescent pigments may be used for each color, or they may be used as a mixture.

The pigments represented by the chemical formulae (8), (9) and (10) may be used as the fluorescent pigments as described above.

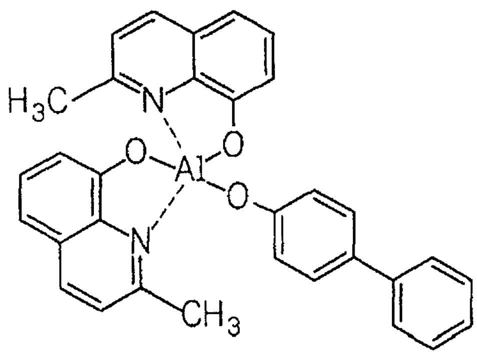

BALQ

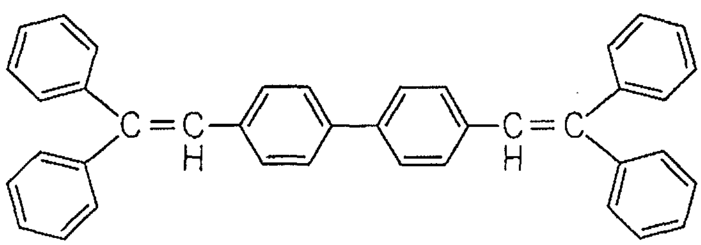

DSA

•••(8)

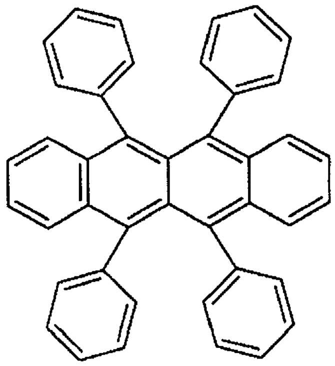

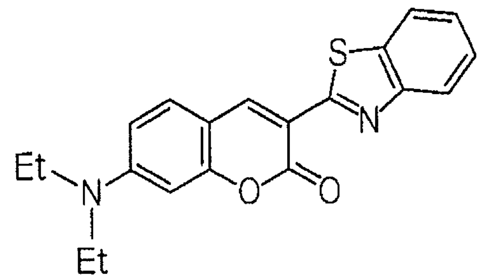

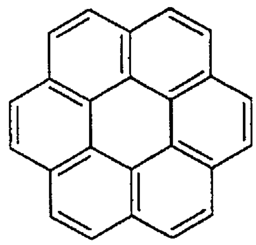

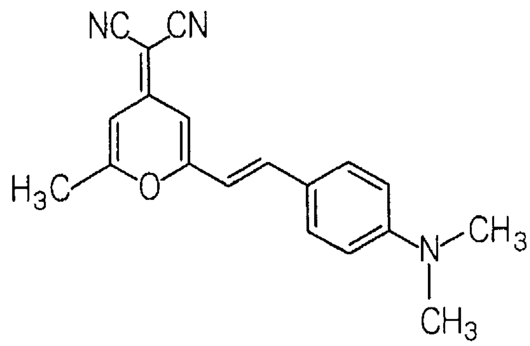

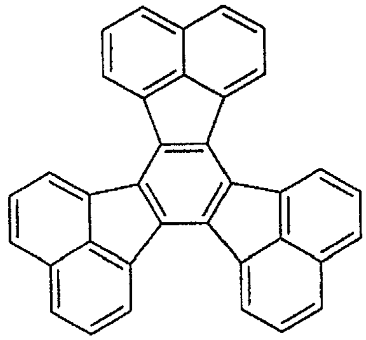

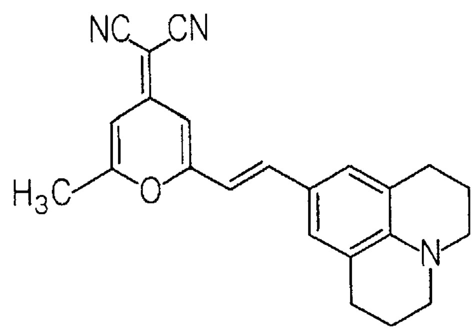

•••(9)

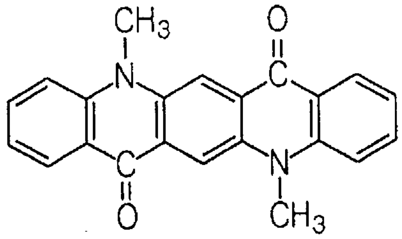

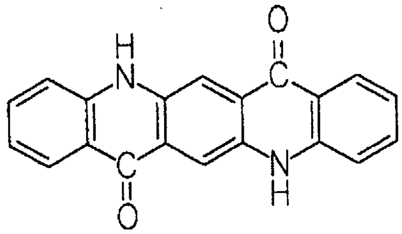

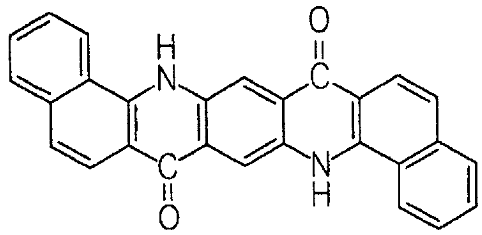

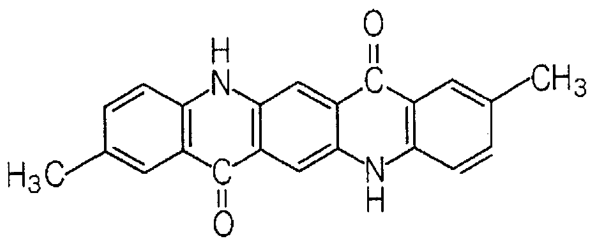

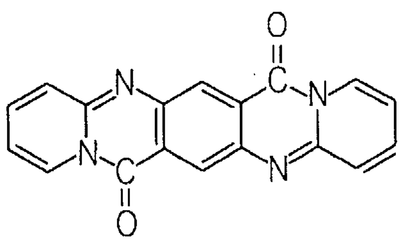

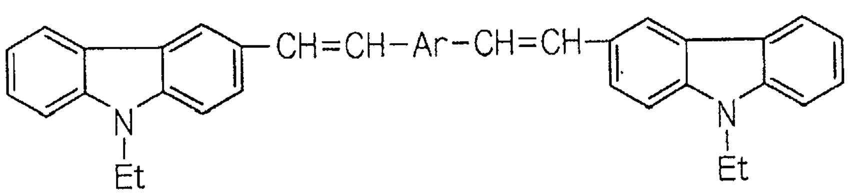

BCzVB Ar= 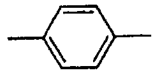

BCzVBi Ar= 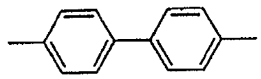 •••(10)

These fluorescent pigments may be added preferably in a proportion of 0.5 to 10 wt%, more preferably 1.0 to 5.0 wt%, to the host material comprising the conjugated organic polymer compounds. Good weather resistance and durability of the luminous layer obtained cannot be maintained when the amount of addition is too large, while the effect

for adding the fluorescent pigment cannot be fully manifested when the amount of addition is too small.

The favorable luminescent substances as the guest materials to be added to the host materials are Ir(ppy), $Pt(thpy)_2$ and PtOEP represented by the chemical formula (11).

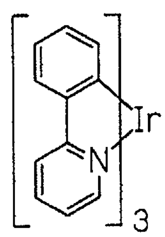

$Ir(ppy)_3$

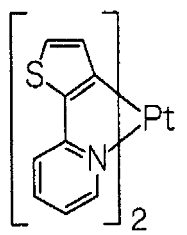

$Pt(thpy)_2$

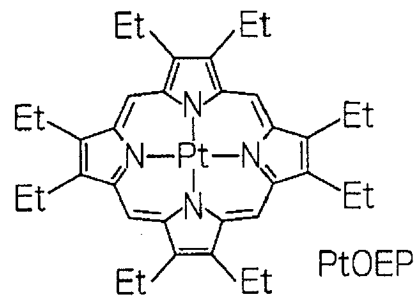

PtOEP

•••(11)

When the luminescent substances represented by the chemical formula (11) are used as the guest materials, CBP, DCTA and TCBP represented by the chemical formula (12) as well as DPVBi and Alq3 described above are preferably used.

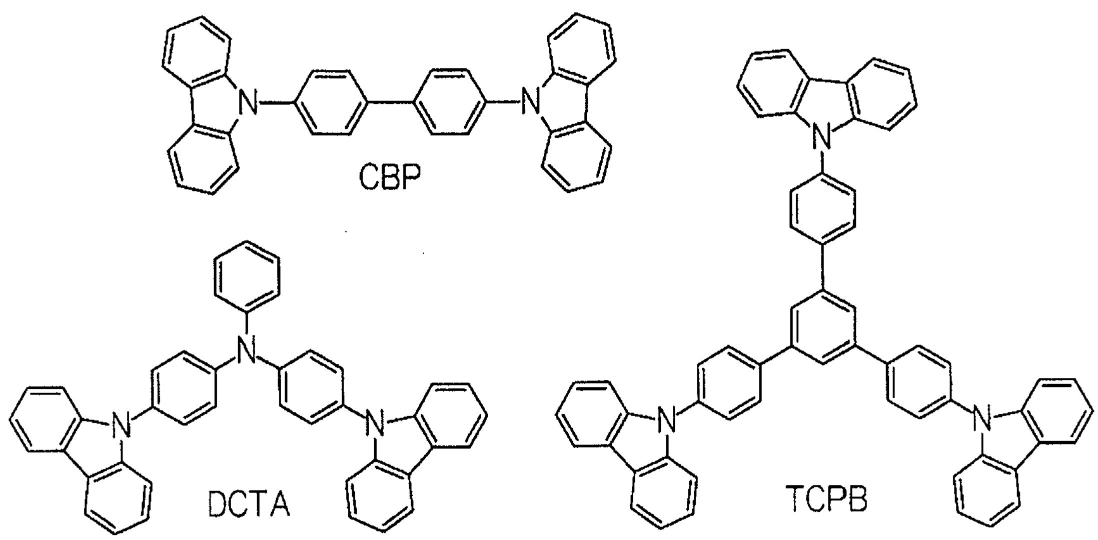

CBP

DCTA

TCPB

•••(12)

The fluorescent pigment and luminescent substance may be added to the host material as the guest materials.

A luminous layer 60 comprising a luminous substance in which a desired amount of the guest material is added to the host material may be formed by previously providing a plurality of material feed systems such as nozzles in the patterning apparatus (an ink-jet apparatus), and by allowing the host material and guest material to be simultaneously discharged in a prescribed volume ratio, when the fluorescent layer 60 is formed using the host/guest luminous substances.

The luminous layer 60 is formed by the same procedure as forming the positive hole injection/transfer layer 70. The luminous layer 60 is formed on the positive hole injection/transfer layer 70 within the opening 221a formed on the third insulating layer 221, by discharging the composite ink containing the luminous layer material on the surface of the positive hole injection/transfer layer 70 followed by drying and heat treatment. The luminous layer is also formed

in an inert gas atmosphere as described above. Since the discharged composite ink is repelled at the region subjected to ink-repelling treatment, the repelled ink drops roll into the opening 221a of the third insulating layer 221 even when the ink drops has failed to hit the prescribed discharge positions.

The electron transfer layer 50 is formed on the surface of the luminous layer 60. The electron transfer layer 50 is also formed by the ink-jet method as forming the luminous layer 60. The material for forming the electron transfer layer 50 is not particularly restricted, and examples of the material include oxadiazole drivatives, anthraquinodimethane and derivatives thereof, benzoquinone and derivatives thereof, naphthoquinone and derivatives thereof, anthraquinone and derivatives thereof, tetracyanoanthraquinone dimethane and derivatives thereof, tetracanoanthraquinone and derivatives thereof, fluorenone derivatives, diphenyldicyanoethylene and derivatives thereof, diphenoquinone derivatives, and 8-hydroxyquinoline and metal complexes of the derivatives thereof. Examples thereof are disclosed in Japanese Unexamined Patent Application Publication Nos. 63-70257, 63-175860, 2-135359, 2-135361, 2-209988, 3-37992 and 3-152184 as in the materials for forming the positive hole transfer layer, and suitable examples thereof are 2-(4-biphenyl)-5-(4-t-butylphenyl)-1,3,4-pxadiazole, benzoquinone, anthraquinone and tris(8-quinolinol)aluminum.

The material for forming the positive hole injection/transfer layer 70 and the material for forming the electron transfer layer 50 may be mixed with the material for forming the luminous layer 60 to from the luminous layer. Although the amount of use of the material for forming the positive hole injection/transfer layer and the amount of use of the material for forming the electron transfer layer are different depending on the kinds of the materials used, they are appropriately determined considering sufficient film forming ability and luminous characteristics. The amount of use is usually 1 to 40% by weight, more preferably 2 to 30% by weight relative to the amount of the material for forming the luminous layer.

The ink-jet method as well as a mask vapor deposition method may be used for forming the positive hole injection/transfer layer 70 and electron transfer layer 50.

The cathode 222 is formed over the entire surface of the electron transfer layer 50 and third insulating layer 221, or as stripes. Although the cathode 222 may be formed into a monolayer comprising Al, Mg, Li or Ca only, or comprising an alloy of Mg and Ag (a 10:1 alloy), it may be formed as a metal laminate (including an alloy) comprising two or three layers. Examples of the laminated structure available include $Li_2O$ (about 0.5 nm)/Al, LiF (about 0.5 nm) /Al and $MgF_2$/Al. The cathode 222 is a light permeable thin layer comprising the metals as described above.

The seal layer 20 is provided for blocking the air from invading into the organic EL element from the outside, and is formed so as to cover the barrier layer 285 and cathode 222. The material available for forming the seal layer 20 includes ceramics such as silicon nitride, silicon oxide nitride and silicon oxide, and the seal layer 20 is formed by the same procedure as forming the first interlayer insulating layer 283. It is effective to construct the seal layer 20 using the same material as used for the barrier layer 285.

Since insulating layers comprising a low dielectric constant material are provided between the electrodes of TFTs 22 and 24, and between the wiring lines (for example scanning line 131, signal line 132 and power line 133 for light emission) connected to the electrodes, it is possible to reduce the parasitic capacitance generated between the electrodes and wiring lines. Consequently, the addressing signals supplied to the TFTs 22 and 24 are reliably isolated with each other to enable the luminous layer 60 to be precisely addressed. Reducing the parasitic capacitance also permits the TFTs 22 and 24 to be operated by the driving signals having higher frequency.

A low dielectric constant layer disposed between a signal line or scanning line of which potential fluctuates according to an electric signal and an electrode and a wire of which potential is fixed at a predetermined value such as a common electrode opposed to a pixel electrode (for example, cathode 222) play an important role in reduction of parasitic capacitance involved with the signal line or the scanning line to overcome problems of deterioration or delay of the electric signal.

Accordingly, stable display operation and large area display (wide screen) can be realized in the electro-optical device 1.

The active elements can be prevented from being deteriorated by invasion of metal components, gases in the air and moisture as a result of forming the barrier layer 285 so as to cover the TFTs 22 and 24, thereby realizing stable display of the electro-optical device 1 for a long period of time.

Especially, when a low dielectric constant layer is porous, invasion of factors for deterioration of device such as metal components, gases in the air and moisture occurs easily. A barrier layer and a low dielectric constant layer disposed between an active element such as transistor and source of deterioration factor such as cathode222 realize long-term stability of display in addition to reduction of deterioration or delay of an electric signal. Forming the seal layer 20 so as to cover the surface of the cathode 222 permits metal components, gases in the air and moisture to be prevented from invading into the luminous layer 60 from the outside. Consequently, the cathode 222 and luminous layer 60 is prevented from being deteriorated to enable the electro-optical device 1 to be stably operated for a long period of time.

Although the first interlayer insulating layer 283 and second interlayer insulating layer 284 have been formed using respective porous low dielectric constant substances in this embodiment, all of these layers are not necessarily

formed of the low dielectric constant materials, and at least any one of the layers may be formed using the low dielectric constant material.

While the barrier layer 285 has been formed on the first interlayer insulating layer 283, the same effect is obtained when the barrier layer is formed on the second interlayer insulating layer 284.

Otherwise, the electro-optical device 1 may be constructed by appropriately combining the position of the barrier layer 285 and the kinds of the materials for forming the first interlayer insulating layer 283 and second interlayer insulating layer 284.

A hole blocking layer may be formed, for example, at the opposed electrode 222 side of the luminous layer 60 for prolonging the service life of the luminous layer 60, in addition to the positive hole injection/transfer layer 70, luminous layer 60 and electron transfer layer 50. While examples of the material available for forming the hole blocking layer include BCP represented by the chemical formula (13) and BAlq represented by the chemical formula (14), BA1q is preferable for prolonging the service life.

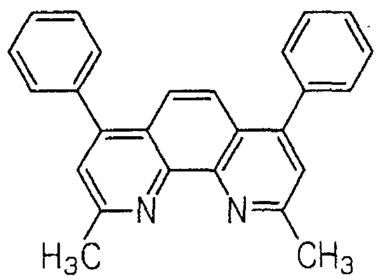

···(13)

BCP

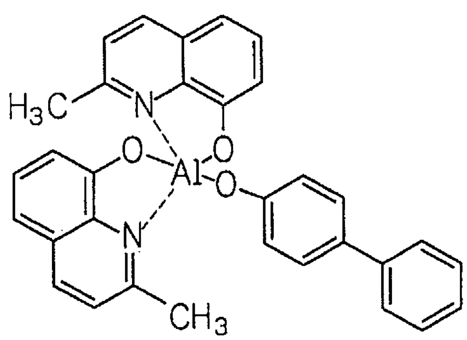

···(14)

BAlq

Examples of the electronic appliances comprising the electro-optical device according to the embodiment will be described hereinafter.

Fig. 4 is a perspective view showing an example of a portable phone. In the drawing, the reference numeral 1000 denotes the main unit of the portable phone and the reference numeral 1001 denotes a display using the electro-optical device as described above.

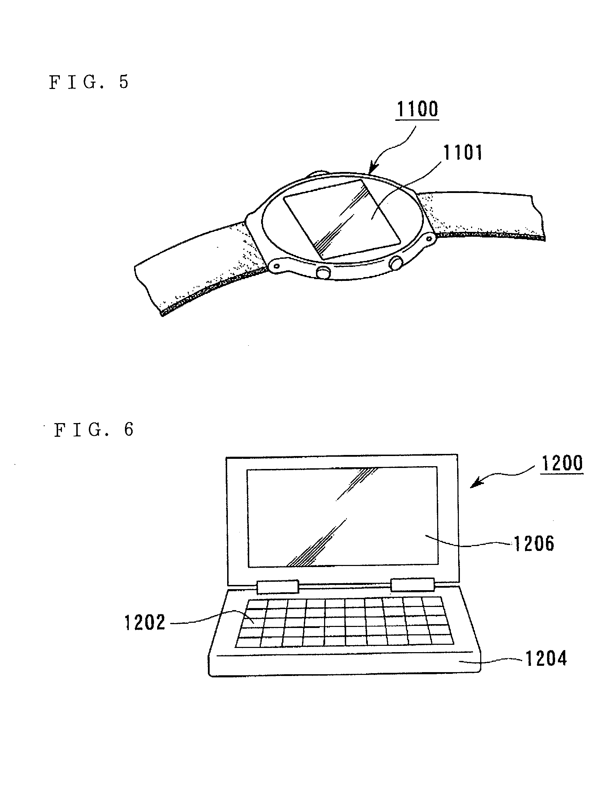

Fig. 5 is a perspective view showing an example of a watch type electronic appliances. In this drawing, the reference numeral 1100 denotes a main unit of the watch, and the reference numeral 1101 denotes a display using the electro-optical device as described above.

Fig. 6 is a perspective view showing an example of a portable type information processing apparatus such as a word processor and personal computer. In the drawing, the reference numeral 1200 denote an information processor, the reference numeral 1202 denote an input device such as a key board, the reference numeral 1204 denotes a main unit of the information processor, and the reference numeral 1206 denotes a display using the electro-optical device as described above.

Since the electronic appliances show in Figs. 4 to 6 comprise the electro-optical device according to the embodiment above, the parasitic capacitance between the wiring lines and electrodes is reduced to enable the electronic appliances to be stably operated.

The range of the technology of the invention is not restricted to the embodiments as described above, and various modifications are possible within the range not departing from the spirit of the invention. For example, the organic EL element has been constructed by interposing the luminous layer and positive hole transfer layer between a pair of electrodes, other organic layers having a variety of functions such as the electron transfer layer, positive hole injection layer and electron injection layer may be interposed in addition to the luminous layer and positive hole transfer layer. The actually used materials described in the embodiments is merely examples, and they may be appropriately changed.

It is possible to replace the luminous layer 60 with other optical display substances such as a liquid crystal layer.

While a so-called back emission type display device 1 in which the light is emitted from the substrate 2 side on which TFTs 22 and 24 are disposed has been described in the embodiment, the display device is not restricted thereto, and it may be a so-called top emission type display device in which the light is emitted from the side opposed to the substrate 2 side on which TFTs 22 and 24 are disposed.

[Advantages]

The parasitic capacitance generated between the electrode or wiring lines can be reduced in the invention, since the insulating layers for insulating between the electrode of the active elements, and between the wiring lines connected to respective electrodes contain insulating layers composed of insulating materials having a dielectric constant below a prescribed value. Consequently, addressing signals supplied to the active elements are reliably isolated from each other to enable the electro-optical element to be precisely addressed by each active element. Reducing the parasitic capacitance permits each active element to be operated with an addressing signal with a higher frequency. Accordingly, a stable display is possible in the electro-optical device having a wide display screen.

The active element can be prevented from being deteriorated by protecting it from invasion of metal components, gases in the air and moisture. Consequently, the circuit substrate and electro-optical device are able to be stably operated for a long period of time.

The second protective layer is formed so as to cover the cathode in order to prevent metal components, gases in the air and moisture from invading into the electro-optical element from the outside. Consequently, the electro-optical element is prevented from being deteriorated to enable it to serve as a stable display for a long period of time.

## Claims

1. A circuit substrate comprising an insulating substrate, an active element disposed above the insulating substrate, a wiring line for supplying an electric signal or a driving electric power for driving the active element, and an insulating layer including an insulating material, the insulating material having a dielectric constant lower than that of the insulating substrate.

2. The circuit substrate according to Claim 1, further comprising a pixel electrode connected to the active element, the insulating layer being disposed between the pixel electrode and the insulating substrate.

3. The circuit substrate according to Claim 1 or 2, wherein the active element is a transistor.

4. The circuit substrate according to any one of Claims 1 to 3, wherein the dielectric constant of the insulating material is 3 or less.

5. The circuit substrate according to any one of Claims 1 to 4, wherein the dielectric constant of the insulating material is 2.5 or less.

6. The circuit substrate according to any one of Claims 1 to 5, wherein the insulating material comprises at least one of a porous material, aerogel, porous silica, magnesium fluoride, fluorinated polymer and porous polymer.

7. The circuit substrate according to any one of Claims 1 to 6, wherein the insulating material comprises at least one of a spin-on glass layer, diamond layer and fluorinated amorphous carbon layer containing any one of silica glass, alkyl siloxane polymer, alkyl silsesquioxane polymer, hydrogenated alkyl silsesquioxane polymer and polyalkyl ether.

8. The circuit substrate according to any one of Claims 1 to 7, wherein the insulating material comprises at least one of inorganic fine particles and organic fine particles contained in a prescribed material.

9. The circuit substrate according to Claim 8, wherein the insulating material contains a gel in which fine particles of magnesium fluoride are dispersed.

10. The circuit substrate according to any one of Claims 1 to 9 further comprising a protective layer formed so as to cover the active element.

11. The circuit substrate according to Claim 10, wherein the protective layer contains at least one of a drying agent and chemical adsorbent.

12. The circuit substrate according to Claim 10 or 11, wherein the protective layer comprises at least one of ceramic, silicon nitride, silicon oxide nitride and silicon oxide.

13. The circuit substrate according to any one of Claims 10 to 12, wherein the protective layer contains at least one of boron, carbon and nitrogen, and at least one of aluminum, phosphorous and silicon; at least one of cerium, ytterbium, samarium, erbium, yttrium, lanthanum, gadolinium, dysprosium and neodymium, and aluminum, silicon, nitrogen and oxygen; or at least one of barium oxide, calcium oxide, activated carbon and zeolite.

14. An electro-optical device comprising:

a substrate;
a cathode disposed above the substrate;
an anode disposed above the substrate;
an electro-optical element interposed between the cathode and the anode; and
an insulating layer disposed between the substrate and at least one of the cathode and the anode, the insulating layer including an insulating material having a dielectric constant that is a prescribed value or less.

15. The electro-optical device according to Claim 14 further comprising an active element for addressing the electro-optical element.

16. The electro-optical device according to Claim 14 or 15, wherein the substrate comprises an insulating material.

17. The electro-optical device according to any one of Claims 14 to 16, wherein the active element is a transistor.

18. The electro-optical device according to any one of Claims 14 to 17, wherein the prescribed value of the dielectric constant is 4 or less.

19. The electro-optical device according to any one of Claims 14 to 18, wherein the prescribed value of the dielectric constant is 3 or less.

20. The electro-optical device according to any one of Claims 14 to 19, wherein the prescribed value of the dielectric constant is 2.5 or less.

21. The electro-optical device according to any one of Claims 14 to 20, wherein the insulating material comprises at least one of a porous material, aerogel, porous silica, magnesium fluoride, fluorinated polymer and porous polymer.

22. The electro-optical device according to any one of Claims 14 to 21, wherein the insulating material comprises at least one of spin-on glass layer, diamond layer and fluorinated amorphous carbon layer containing any one of silica glass, alkyl siloxane polymer, alkyl silsesquioxane polymer, hydrogenated alkyl silsesquioxane polymer and polyalkyl ether.

23. The electro-optical device according to any one of Claims 14 to 22, wherein the insulating material comprises at least one of inorganic fine particles and organic fine particles contained in a prescribed material.

24. The electro-optical device according to Claim 23, wherein the insulating material contains a gel in which fine particles of magnesium fluoride are dispersed.

**25.** The electro-optical device according to any one of Claims 14 to 24 further comprising a first protective layer formed so as to cover the active element.

**26.** The electro-optical device according to any one of Claims 14 to 25 further comprising a second protective layer formed so as to cover the cathode.

**27.** The electro-optical device according to Claim 25 or 26, wherein at least one of the first and second protective layers contains at least one of the drying agent and chemical adsorbent.

**28.** The electro-optical device according to any one of Claims 25 to 27, wherein at lest one of the first and second protective layers comprises at least one of ceramic, silicon nitride, silicon oxide nitride and silicon oxide.

**29.** The electro-optical device according to any one of Claims 25 to 28, wherein at least one of the first and second protective layers contains at least one of boron, carbon and nitrogen, and at least one of aluminum, phosphorous and silicon; at least one of cerium, ytterbium, samarium, erbium, yttrium, lanthanum, gadolinium, dysprosium and neodymium, and aluminum, silicon, nitrogen and oxygen; or at least one of barium oxide, calcium oxide, activated carbon and zeolite.

**30.** The electro-optical device according to any one of Claims 14 to 29, wherein the electro-optical device is an organic electroluminescence element.

**31.** Electronic appliances comprising the circuit substrate according to any one of Claims 1 to 13, or the electro-optical device according to any one of Claims 14 to 30.

FIG. 1

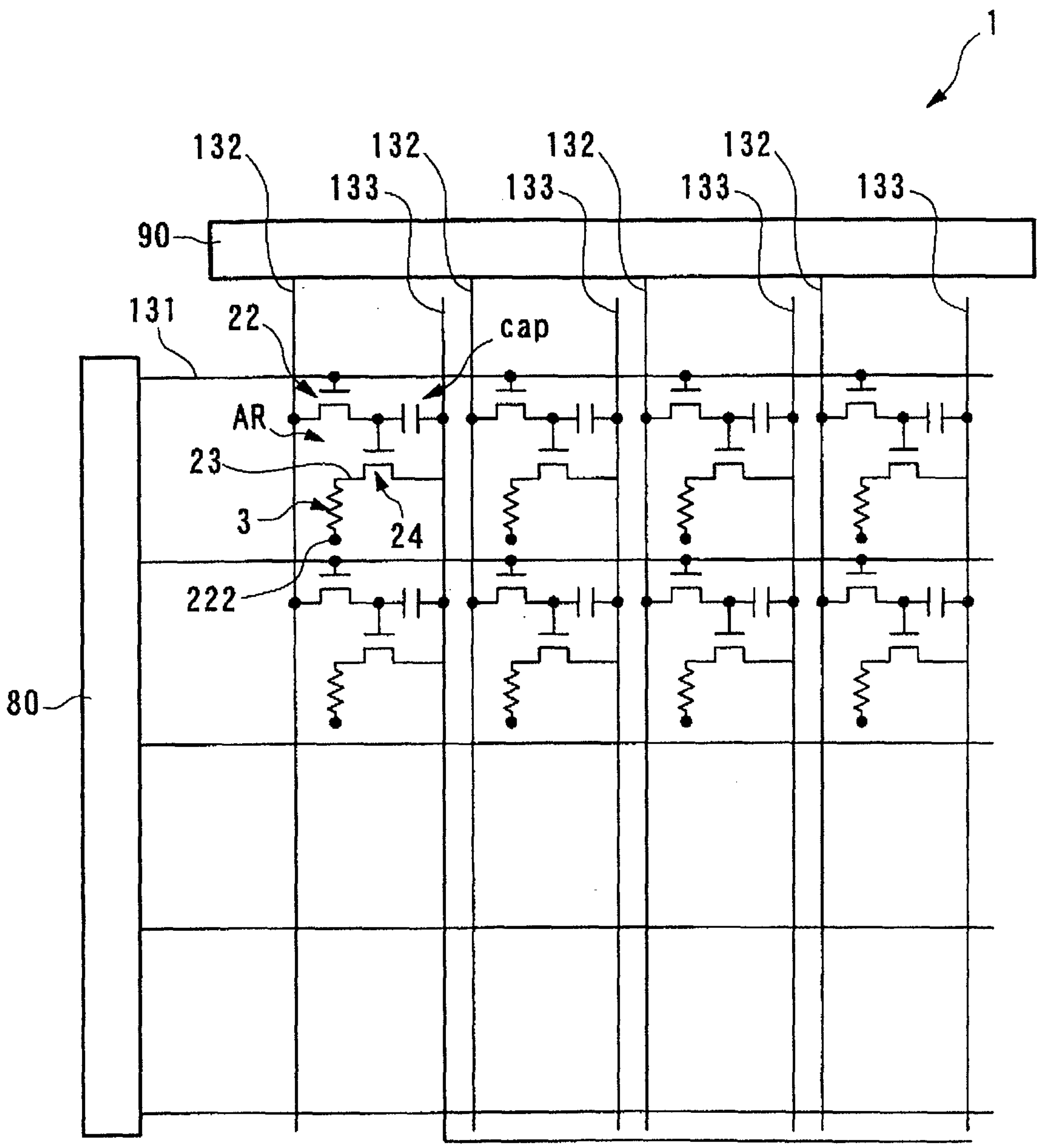

FIG. 2

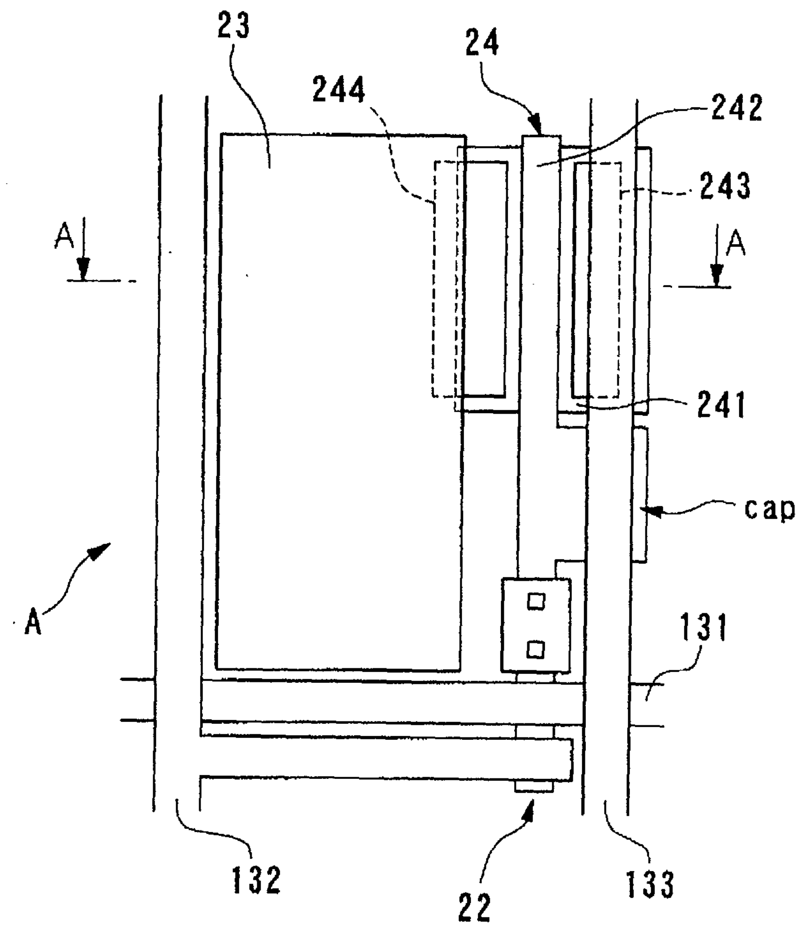

FIG. 3

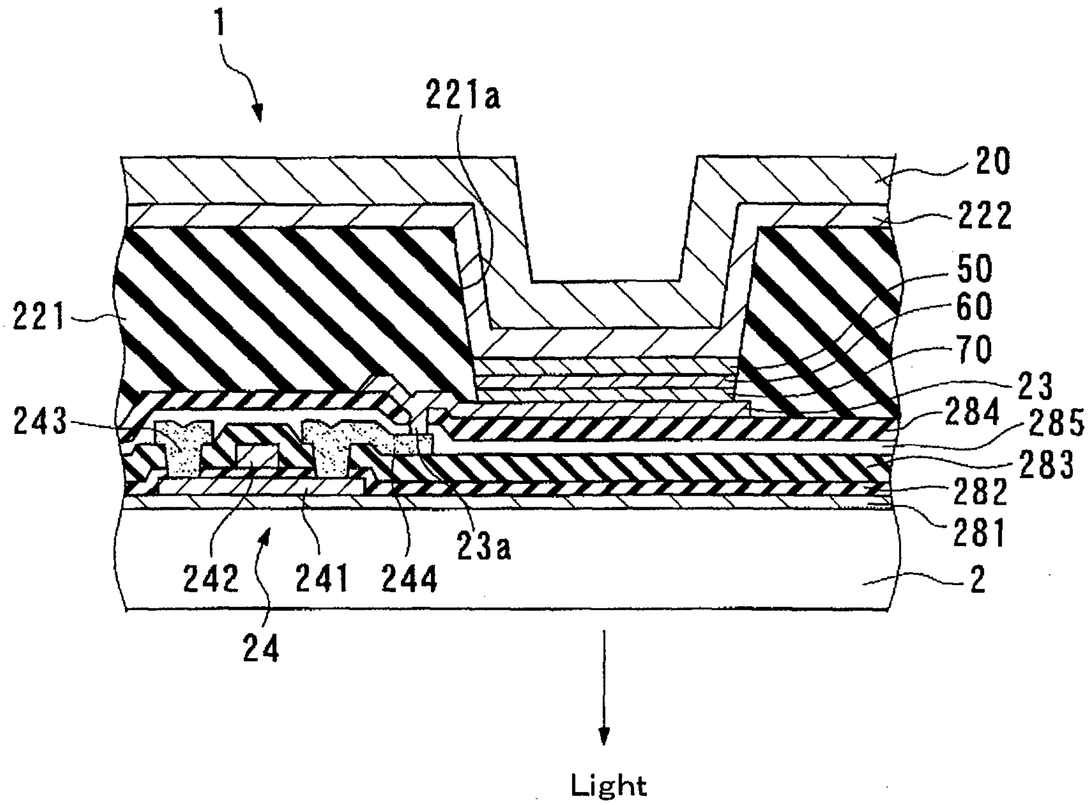
1
221a
20
222
50
60
70
23
284
285
283
282
281
2
221
243
242
241
244
23a
24
Light

FIG. 4

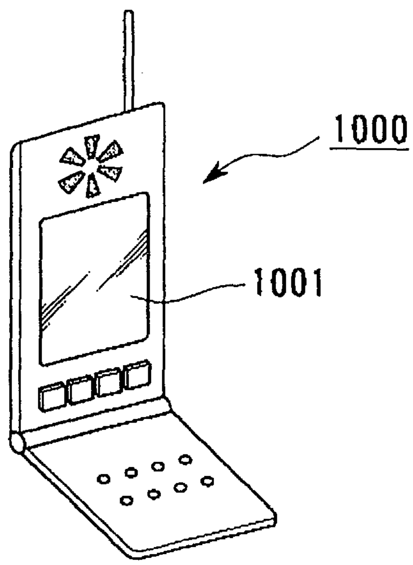
1000
1001

FIG. 5

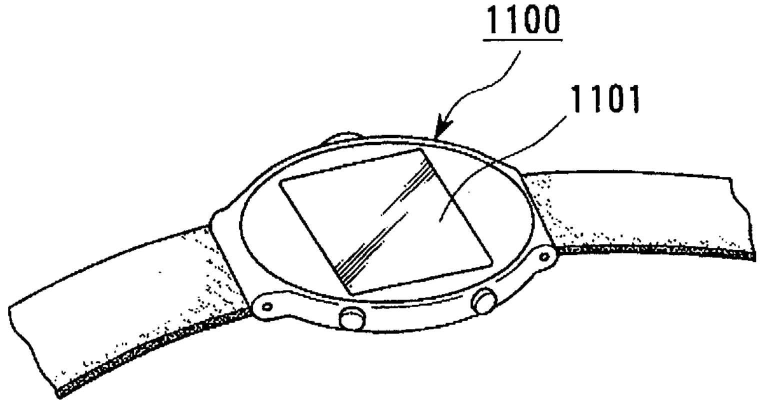


FIG. 6